# EUROPEAN PATENT APPLICATION

(11) **EP 4 693 289 A1**
(43) Date of publication of application: **11.02.2026**
(21) Application number: 25193874.2
(22) Date of filing: 04.08.2025
(51) Int. Cl.: G11C 5/06, H01L 21/768, H01L 23/00, H01L 25/065, H10D 84/83, H10D 88/00

(54) **STACKED SEMICONDUCTOR DEVICES WITH COUPLED BACKSIDE CONTACTS**

(30) Priority: 05.08.2024 US 202418794201
(71) Applicant: Intel Corporation, Santa Clara, CA 95054 (US)
(72) Inventor: LI, Xia, San Diego, 92130 (US); APRAMEYAN, Prashanth, San Jose, 95135 (US)
(74) Representative: 2SPL Patentanwälte PartG mbB

(57) **Abstract**

Techniques are provided herein to form an integrated circuit having stacked semiconductor devices with their source or drain regions coupled together via matching backside connections. In an example, FET (field effect transistor) devices may be formed on two different substrates and bonded together at their backsides such that backside contacts beneath each device substantially align at or near the bonding interface. The substrate beneath both the first FET and the second FET is removed, and backside contacts are formed beneath the source or drain regions of the first and second FETs. A bonding layer may also be formed on the backside of either the first FET or the second FET. The second FET is then flipped upside down and bonded to the backside of the first FET, such that the backside contacts from the first and second FET's are substantially aligned and are conductively coupled through the bonding layer.

## Description

### BACKGROUND

As integrated circuits continue to scale downward in size, a number of challenges arise. For instance, reducing the size of memory and logic cells within the interconnect structure is becoming increasingly more difficult, as is reducing device spacing at the device layer. Some circuit designs utilize more than one layer of devices (e.g., devices stacked over one another in a Z-direction) to further increase the device density in a given footprint. However, there remain a number of non-trivial challenges with respect to forming such high-density semiconductor devices.

### BRIEF DESCRIPTION OF THE DRAWINGS

Figure 1A is a cross-sectional view of stacked semiconductor devices in an integrated circuit that include coupled backside interconnects, in accordance with an embodiment of the present disclosure.
Figure 1B is a cross-sectional view of the stacked semiconductor devices from Figure 1A in an orthogonal direction across the coupled backside interconnects, in accordance with an embodiment of the present disclosure.
Figure 1C is a cross-sectional view of the stacked semiconductor devices from Figure 1A in an orthogonal direction across another configuration of the coupled backside interconnects, in accordance with an embodiment of the present disclosure.
Figures 2A and 2B are cross-sectional views that illustrate one stage in an example process for forming an integrated circuit having stacked semiconductor devices that include coupled backside interconnects, in accordance with an embodiment of the present disclosure.
Figures 3A and 3B are cross-sectional views that illustrate another stage in the example process for forming an integrated circuit having stacked semiconductor devices that include coupled backside interconnects, in accordance with an embodiment of the present disclosure.
Figures 4A and 4B are cross-sectional views that illustrate another stage in the example process for forming an integrated circuit having stacked semiconductor devices that include coupled backside interconnects, in accordance with an embodiment of the present disclosure.
Figures 5A and 5B are cross-sectional views that illustrate another stage in the example process for forming an integrated circuit having stacked semiconductor devices that include coupled backside interconnects, in accordance with an embodiment of the present disclosure.
Figures 6A and 6B are cross-sectional views that illustrate another stage in the example process for forming an integrated circuit having stacked semiconductor devices that include coupled backside interconnects, in accordance with an embodiment of the present disclosure.
Figures 7A and 7B are cross-sectional views that illustrate another stage in the example process for forming an integrated circuit having stacked semiconductor devices that include coupled backside interconnects, in accordance with an embodiment of the present disclosure.
Figures 8A and 8B are cross-sectional views that illustrate another stage in the example process for forming an integrated circuit having stacked semiconductor devices that include coupled backside interconnects, in accordance with an embodiment of the present disclosure.
Figures 9A and 9B are cross-sectional views that illustrate another stage in the example process for forming an integrated circuit having stacked semiconductor devices that include coupled backside interconnects, in accordance with an embodiment of the present disclosure.
Figures 10A and 10B are cross-sectional views that illustrate another stage in the example process for forming an integrated circuit having stacked semiconductor devices that include coupled backside interconnects, in accordance with an embodiment of the present disclosure.
Figures 11A and 11B are cross-sectional views that illustrate another stage in the example process for forming an integrated circuit having stacked semiconductor devices that include coupled backside interconnects, in accordance with an embodiment of the present disclosure.
Figures 12A and 12B are cross-sectional views that illustrate another stage in the example process for forming an integrated circuit having stacked semiconductor devices that include coupled backside interconnects, in accordance with an embodiment of the present disclosure.
Figures 13A and 13B are cross-sectional views that illustrate another stage in the example process for forming an integrated circuit having stacked semiconductor devices that include coupled backside interconnects, in accordance with an embodiment of the present disclosure.
Figures 14A and 14B are cross-sectional views that illustrate another stage in the example process for forming an integrated circuit having stacked semiconductor devices that include coupled backside interconnects, in accordance with an embodiment of the present disclosure.
Figure 15 is a cross-sectional view that illustrates another stage in the example process for forming an integrated circuit having stacked semiconductor devices that include coupled backside interconnects, in accordance with an embodiment of the present disclosure.
Figure 16 is a cross-sectional view that illustrates another stage in the example process for forming an integrated circuit having stacked semiconductor devices that include coupled backside interconnects, in accordance with an embodiment of the present disclosure.
Figures 17A and 17B are cross-sectional views that illustrate another example integrated circuit having stacked semiconductor devices that include coupled backside to frontside interconnects, in accordance with an embodiment of the present disclosure.
Figure 18 illustrates a cross-sectional view of a chip package containing one or more semiconductor dies, in accordance with some embodiments of the present disclosure.
Figure 19 is a flowchart of a fabrication process for stacked semiconductor devices in an integrated circuit that include coupled backside interconnects, in accordance with an embodiment of the present disclosure.
Figure 20 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form an integrated circuit having stacked semiconductor devices with their source or drain regions coupled together via matching backside connections. In an example, devices may be formed on two different substrates and bonded together at their backsides such that backside contacts beneath each device substantially align at or near the bonding interface. The techniques can be used in any number of integrated circuit applications and are particularly useful with respect to logic and memory cells, such as those cells that use gate-all-around transistors (e.g., ribbonFETs and nanowire FETs) or forksheet transistors. In one such example, a first FET (field effect transistor) and a second FET are formed on two different substrates, and each includes semiconductor material extending in a first direction between source and drain regions. Each FET also includes a gate structure extending in a second direction around the semiconductor material of each FET. The semiconductor material of each FET may be, for instance, one to four nanowires (or nanoribbons or nanosheets, as the case may be). Backside processing may be used to remove the substrate beneath both the first FET and the second FET, and backside contacts may be formed beneath the source or drain region of the first FET and the second FET. A bonding layer may also be formed on the backside of either the first FET or the second FET. The second FET is then flipped upside down and bonded to the backside of the first FET, such that the backside contacts from the first and second FET's are substantially aligned and are conductively coupled through the bonding layer. A hybrid bonding process may be used to bond the devices together. Numerous variations and embodiments will be apparent in light of this disclosure.

### General Overview

As previously noted above, there remain a number of non-trivial challenges with respect to integrated circuit fabrication. In more detail, devices may be stacked over one another to increase the device density in a given footprint on a chip. Stacking devices brings inherent challenges such as maintaining interconnects among the devices.

Thus, and in accordance with an embodiment of the present disclosure, techniques are provided herein to form stacked semiconductor devices with backside coupled connections. The semiconductor devices are formed across two different substrates that are later bonded together to form the stacked architecture. According to some embodiments, a bonding layer is also formed beneath one of the devices to facilitate a hybrid bond between the devices, and also to provide a conductive landing pad to be shared between backside contacts of both devices. It should be noted that spatially relative terms like "frontside", "above", "below", and "backside" refer to the orientation of the device during its fabrication process (e.g., with the substrate on the backside of the device), before bonding occurs. Once a device has been flipped and bonded to another, these terms may continue to be used in the same way to identify features of the flipped device. For example, a backside contact formed beneath one device will continue to be identified as a backside contact even after that device has been flipped upside down.

According to some embodiments, the backside contact of a given device extends along an entire height of a corresponding source or drain region to also contact a topside contact of the corresponding source or drain region. In some examples, the backside contact also directly contacts the corresponding source or drain region while in other examples the backside contact is spaced laterally from the corresponding source or drain region and contacts the topside contact.

According to an embodiment, an integrated circuit includes a first semiconductor region extending from a first source or drain region in a first direction, a first gate structure extending over the first semiconductor region in a second direction substantially orthogonal to the first direction, a second semiconductor region extending from a second source or drain region in the first direction, and a second gate structure extending over the second semiconductor region in the second direction. The second source or drain region is spaced from the first source or drain region in a third direction substantially orthogonal to the first and second directions. The integrated circuit also includes a first conductive contact extending in the third direction from the first source or drain region and contacting at least a portion of the first source or drain region, a second conductive contact extending in the third direction from the second source or drain region and contacting at least a portion of the second source or drain region, and a conductive structure between and contacting both the first conductive contact and the second conductive contact.

According to another embodiment, an integrated circuit includes a first semiconductor region extending from a first source or drain region in a first direction, a first gate structure extending over the first semiconductor region in a second direction substantially orthogonal to the first direction, a second semiconductor region extending from a second source or drain region in the first direction, and a second gate structure extending over the second semiconductor region in the second direction. The second source or drain region is spaced from the first source or drain region in a third direction substantially orthogonal to the first and second directions. The integrated circuit also includes a first conductive contact on at least a portion of the first source or drain region, a second conductive contact on at least a portion of the second source or drain region, a third conductive contact adjacent to the first source or drain region and extending in the third direction from the first conductive contact, a fourth conductive contact adjacent to the second source or drain region and extending in the third direction from the second conductive contact, and a conductive structure between and contacting both the third conductive contact and the fourth conductive contact.

According to an embodiment, a method of forming an integrated circuit includes: forming a first semiconductor device on a first substrate, the first semiconductor device having a first semiconductor region extending in a first direction from a first source or drain region and a first gate structure extending over the first semiconductor region in a second direction substantially orthogonal to the first direction; forming a second semiconductor device on a second substrate, the second semiconductor device having a second semiconductor region extending in the first direction from a second source or drain region and a second gate structure extending over the second semiconductor region in the second direction; removing at least a portion of the first substrate from beneath the first semiconductor device and at least a portion of the second substrate from beneath the second semiconductor device; forming a first backside dielectric layer beneath the first semiconductor device and a second backside dielectric layer beneath the second semiconductor device; forming a first backside contact through the first backside dielectric layer, the first backside contact contacting a surface of the first source or drain region; forming a second backside contact through the second backside dielectric layer, the second backside contact contacting a surface of the second source or drain region; forming a third dielectric layer beneath the second dielectric layer; forming a conductive structure through the third dielectric layer, the conductive structure contacting at least a portion of the second backside contact; and bonding the third dielectric layer to the first dielectric layer, such that the conductive structure is bonded to or otherwise contacts at least a portion of the first backside contact.

The techniques can be used with any type of planar or non-planar transistors, including finFET transistors, nanowire and nanoribbon transistors (sometimes called gate-all-around transistors) or forksheet transistors, to name a few examples. The source and drain regions can be, for example, epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of bonded substrates with devices stacked over one another in a Z-direction. Furthermore, conductive contacts extending from both devices (e.g., from source or drain regions of both devices) may extend in the Z-direction to conductively couple with one another at or near the bonding interface. A conductive structure may be observed at the bonding interface to facilitate the connection between the conductive contacts from each device.

It should be readily understood that the meaning of "above" and "over" in the present disclosure should be interpreted in the broadest manner such that "above" and "over" not only mean "directly on" something but also include the meaning of over something with an intermediate feature or a layer therebetween. As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

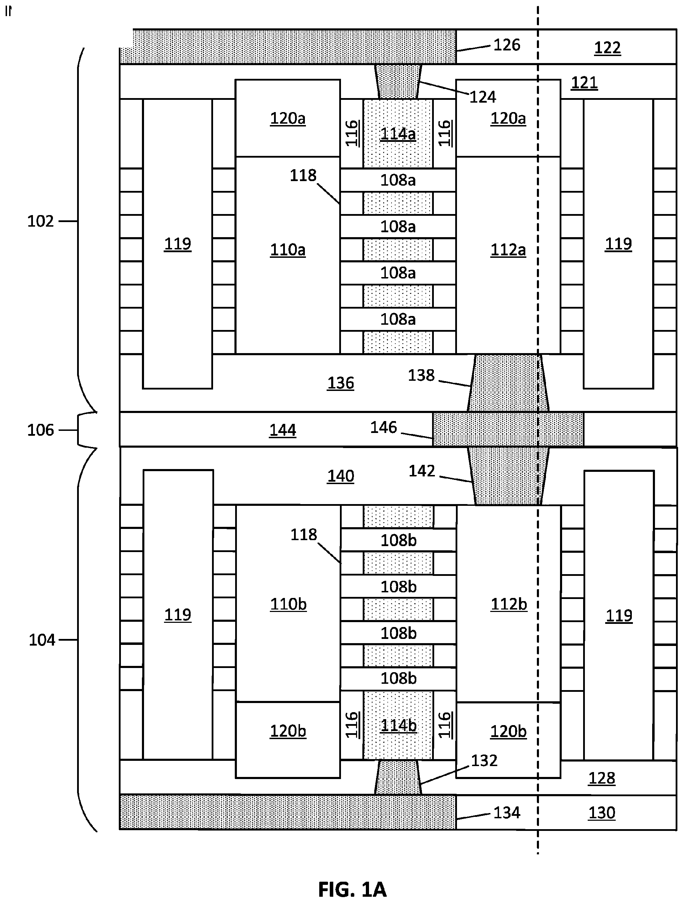

Figure 1A is a cross-section view taken through a first semiconductor device 102 along a 'fin' or nanoribbon direction that illustrates the semiconductor bodies extending between source or drain regions of first semiconductor device 102, and along a second semiconductor device 104 along the same 'fin' or nanoribbon direction, in accordance with an embodiment of the present disclosure. According to some embodiments, first semiconductor device 102 is stacked over second semiconductor device 104 such that at least one source or drain region of first semiconductor device 102 is substantially aligned over at least one source or drain region of second semiconductor device 104 in the Z-direction. of the semiconductor devices may be, for instance, non-planar metal oxide semiconductor (MOS) transistors, such gate-all-around (GAA) transistors, although other transistor topologies and types could also benefit from the techniques provided herein. The examples herein illustrate semiconductor devices with a GAA structure (e.g., having nanoribbons, nanowires, or nanosheets that extend between source and drain regions). Each of first semiconductor device 102 and second semiconductor device 104 may be fabricated on separate substrates that are later removed. The exposed backsides of the first semiconductor device 102 and second semiconductor device 104 (following removal of the substrates) may be bonded together using a bonding layer 106.

The semiconductor material used in each of the semiconductor devices may be formed from or on the corresponding semiconductor substrate. According to some embodiments, each substrate is removed following the completion of all topside processing and is replaced with a base dielectric structure. The base dielectric structure may represent any number of dielectric layers and/or materials.

The one or more semiconductor regions of the devices may include fins of alternating layers of material (e.g., alternating layers of silicon and SiGe) that facilitates forming of nanowires and nanoribbons and nanosheets during a gate forming process where one type of the alternating layers is selectively etched away so as to liberate the other type of alternating layers within the channel region, so that a gate-all-around process or a forksheet gate process can then be carried out. The alternating layers can be blanket deposited and then etched into fins or deposited into fin-shaped trenches, in some examples.

First semiconductor device 102 includes one or more semiconductor regions (also called channel regions), such as one or more nanoribbons 108a extending between an epitaxial first source or drain region 110a and an epitaxial second source or drain region 112a in the first direction. Similarly, second semiconductor device 104 includes one or more semiconductor nanoribbons 108b extending between an epitaxial third source or drain region 110b and an epitaxial fourth source or drain region 112b in the first direction. A first gate structure 114a extends over nanoribbons 108a of first semiconductor device 102 in a second direction (e.g., into and out of the page) to form the transistor gate of first semiconductor device 102 and second gate structure 114b extends over nanoribbons 108b of second semiconductor device 104 in the second direction to form the transistor gate of second semiconductor device 104.

Any of source or drain regions 110a/110b/112a/112b may act as either a source region or a drain region, depending on the application and dopant profile. Any semiconductor materials suitable for source and drain regions can be used (e.g., group IV and group III-V semiconductor materials) for any of the illustrated source or drains regions. In any such cases, the composition and doping of the source or drain regions may be the same or different, depending on the polarity of the transistors. In an example, first semiconductor device 102 may be an n-channel device having a high concentration of n-type dopants in the associated source or drain regions 110a/112a, and second semiconductor device 104 may be a p-channel device having a high concentration of p-type dopants in the associated source or drain regions 110b/112b. Example p-type dopants include boron and example n-type dopants include phosphorous or arsenic. Any number of source and drain configurations and materials can be used.

The gate structures 114a/114b may each include a gate electrode that is made up of a conductive fill and one or more metal workfunction layers, according to some embodiments. The gate structures 114a/114b also include a gate dielectric that may represent any number of dielectric layers. The conductive fill may include any sufficiently conductive material such as a metal, metal alloy, or doped polysilicon. In some examples, the conductive fill includes tungsten (W), although other metals or conductive materials may be used, such as aluminum (Al), molybdenum (Mo), ruthenium (Ru), cobalt (Co), titanium (Ti), tantalum (Ta), or doped polysilicon. In some embodiments, first semiconductor device 102 is an n-channel device having a gate structure 114a with one or more workfunction layers of tungsten. Other metal workfunction layers of n-channel devices can include tantalum nitride (TaN). In some embodiments, second semiconductor device 104 is a p-channel device having gate structure 114b with one or more workfunction layers of tantalum nitride (TaN) and/or titanium nitride (TiN).

The gate dielectric of each gate structure 114a/114b may include any suitable gate dielectric material(s). In some embodiments, the gate dielectric includes a layer of native oxide material (e.g., silicon dioxide germanium dioxide, or SiGe oxide) on nanoribbons 108a/108b, and a layer of high-k dielectric material (e.g., hafnium oxide or aluminum oxide) on the native oxide. According to some embodiments, spacer structures 116 and inner spacers 118 are present along the sidewalls of gate structures 114a/114b. Spacer structures 116 and inner spacers 118 may be any suitable dielectric material, such as silicon nitride, and provide separation between a given gate structure 114a/114b and the adjacent source or drain regions. Inner spacers 118 may separate adjacent nanoribbons 108a/108b from one another along the third direction (e.g., the Z-direction).

According to some embodiments, one or more isolation structures 119 may be formed adjacent to the devices that cut across one or more fins to isolate devices on either side of the isolation structure. Isolation structures 119 may include one or more dielectric materials that extend in the second direction within a gate trench to cut through any number of fins present within the gate trench. In the illustrated example, isolation structures 119 extend along the second direction on either side of first semiconductor device 102 and second semiconductor device 104 to isolate such devices from any other devices formed along the first direction. Isolation structure 119 may include any suitable dielectric material, such as silicon nitride or any other oxide-based dielectric material. According to some embodiments, isolation structure 119 extends in the third direction along at least an entire height of the adjacent source or drain regions. A top surface of isolation structure 119 may be substantially coplanar with a top surface of spacer structures 116. Isolation structures 119 may not be needed in situations where adjacent devices along the first direction are intended to share a given source or drain region (or where dummy transistors are employed).

According to some embodiments, first topside contacts 120a may be used within the source/drain trenches over first source or drain region 110a and second source or drain region 112a, and second topside contacts 120b may be used within the source/drain trenches over third source or drain region 110b and fourth source or drain region 112b. Topside contacts 120a/120b may be any suitable conductive material, such as tungsten, molybdenum, ruthenium, or cobalt, to name a few examples.

According to some embodiments, first semiconductor device 102 includes at least a first topside dielectric layer 121 and a second topside dielectric layer 122 on first topside dielectric layer 121. Each of topside dielectric layers 121/122 may include any suitable dielectric material, such as silicon dioxide, and may be part of a multi-layer interconnect region. In some embodiments, a first topside via 124 is formed through first topside dielectric layer 121 to make contact with first gate structure 114a, and a first topside conductive layer 126 is formed through second topside dielectric layer 122 to make contact with first topside via 124. Similarly, second semiconductor device 104 includes at least a third topside dielectric layer 128 and a fourth topside dielectric layer 130 on third topside dielectric layer 128. Each of topside dielectric layers 128/130 may include any suitable dielectric material, such as silicon dioxide, and may be part of a multi-layer interconnect region. In some embodiments, a second topside via 132 is formed through third topside dielectric layer 128 to make contact with second gate structure 114b, and a second topside conductive layer 134 is formed through fourth topside dielectric layer 130 to make contact with second topside via 132.

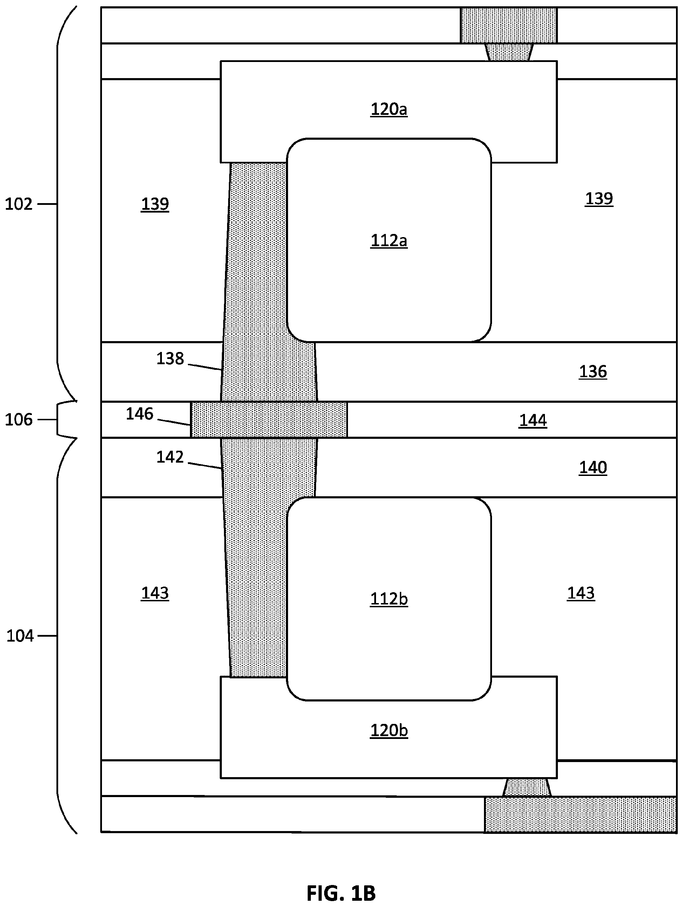

As discussed above, the substrate below first semiconductor device 102 is removed and replaced with a first base dielectric structure 136, which may include any number of dielectric layers. According to some embodiments, a first backside contact 138 extends through first base dielectric structure 136 to contact at least a portion of second source or drain region 112a and at least a portion of first topside contact 120a. Figure 1B illustrates a cross-section view taken through the dashed line of Figure 1A. First backside contact 138 can be seen extending through an entire thickness of first backside dielectric structure 136 and also through a first dielectric fill 139 within the source/drain trench adjacent to second source or drain region 112a. According to some embodiments, first backside contact 138 extends along a side of second source or drain region 112a while also contacting first topside contact 120a.

Prior to the bonding process, the substrate below second semiconductor device 104 is also removed and replaced with a second base dielectric structure 140, which may include any number of dielectric layers. According to some embodiments, a second backside contact 142 extends through second base dielectric structure 140 to contact at least a portion of fourth source or drain region 112b and at least a portion of second topside contact 120b. Second backside contact 142 can be seen extending through an entire thickness of second backside dielectric structure 140 and also through a second dielectric fill 143 within the source/drain trench adjacent to fourth source or drain region 112b, as seen in Figure 1B. According to some embodiments, second backside contact 142 extends along a side of fourth source or drain region 112b while also contacting second topside contact 120b. Each of first backside contact 138 and second backside contact 142 may be any suitable conductive material, such as tungsten, molybdenum, ruthenium, or cobalt, to name a few examples.

According to some embodiments, bonding layer 106 between first semiconductor device 102 and second semiconductor device 104 includes a dielectric layer 144 and a conductive pad 146. Dielectric layer 144 may be any suitable dielectric material, such as silicon dioxide. Conductive pad 146 may include any suitable conductive material, such as tungsten, molybdenum, ruthenium, or cobalt, to name a few examples. According to some embodiments, conductive pad 146 provides a conductive path between first backside contact 138 and second backside contact 142. Accordingly, first backside contact 138 may be aligned with conductive pad 146 or second backside contact 142 may be aligned with conductive pad 146 during the bonding process, as will be discussed in more detail herein.

Note that additional topside vias and topside conductive layers may also be made to connect each of first topside contact 120a and second topside contact 120b to corresponding topside interconnect regions.

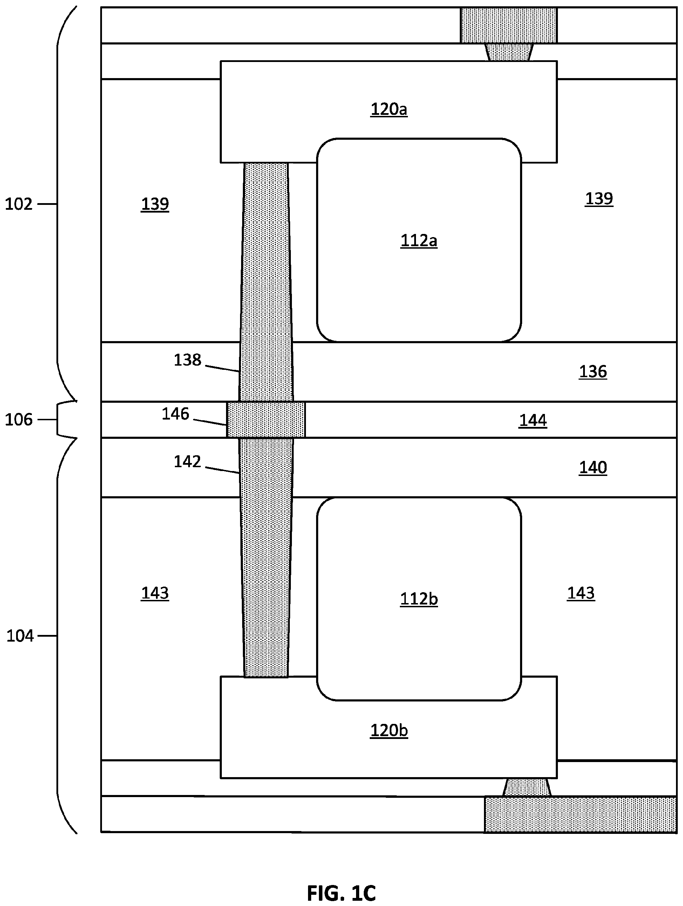

Figure 1C illustrates another example arrangement for first backside contact 138 and second backside contact 142. In the illustrated example, first backside contact 138 is offset from second source or drain region 112a in the second direction such that first backside contact 138 does not contact any portion of second source or drain region 112a. Similarly, second backside contact 142 is offset from fourth source or drain region 112b in the second direction such that second backside contact 142 does not contact any portion of fourth source or drain region 112b.

### Fabrication Methodology

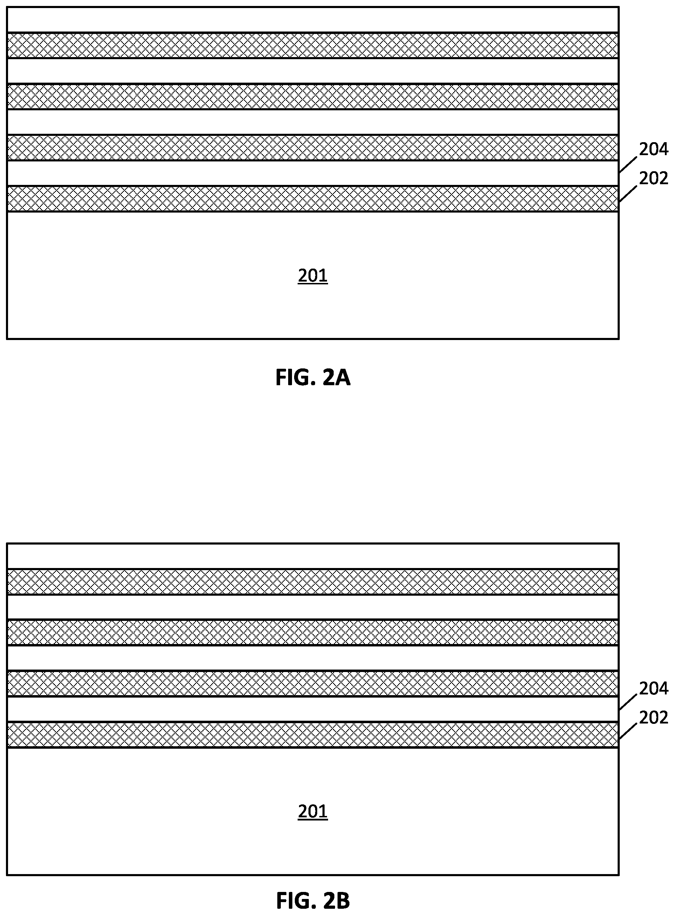

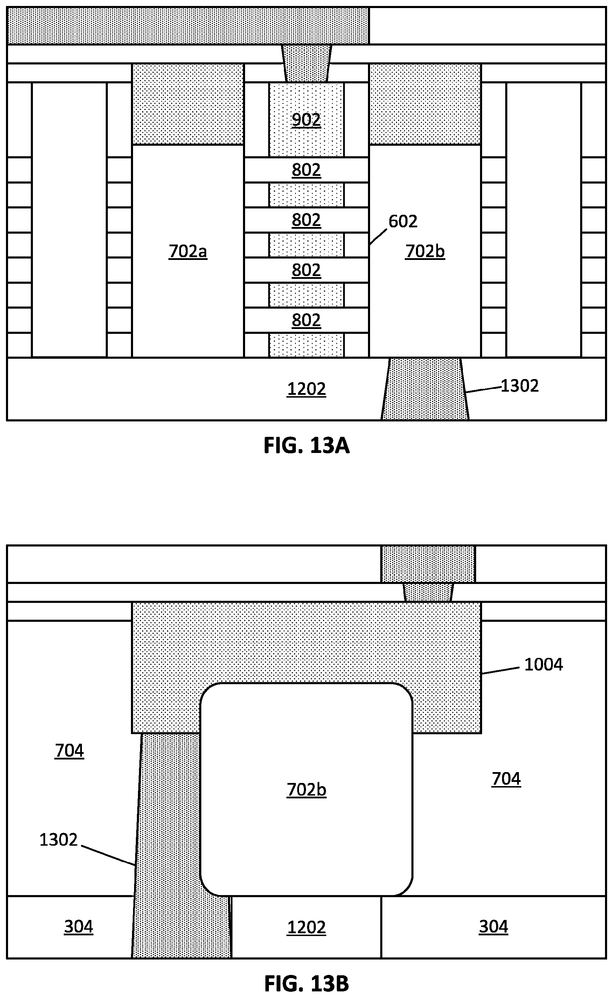

Figures 2A - 13A and 2B - 13B include cross-sectional views that collectively illustrate an example process for forming an integrated circuit that includes stacked semiconductor devices with coupled backside contacts, in accordance with an embodiment of the present disclosure. Figures 2A - 13A represent a similar cross-sectional view as that of Figure 1A (e.g., fin direction), while Figures 2B - 13B represent a similar cross-sectional view as that of Figure 1B (e.g., along the source/drain trench). Each set of figures sharing the same letter shows an example structure that results from the process flow up to that point in time, so the depicted structure evolves as the process flow continues, culminating in the structure shown in Figures 13A and 13B, which is similar to each of first semiconductor device 102 and second semiconductor device 104. The illustrated integrated circuit structure may be part of a larger integrated circuit that includes other integrated circuitry not depicted. Example materials and process parameters are given, but other materials and process parameters may be used as well, as will be appreciated in light of this disclosure.

Figures 2A and 2B each illustrates a cross-sectional view taken through a substrate 201 having a series of material layers formed over the substrate, according to an embodiment of the present disclosure. Alternating material layers may be deposited over a substrate 201 including sacrificial layers 202 alternating with semiconductor layers 204. The alternating layers are used to form GAA transistor structures. Any number of alternating sacrificial layers 202 and semiconductor layers 204 may be deposited over substrate 201.

Substrate 201 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

According to some embodiments, semiconductor layers 204 have a different material composition than sacrificial layers 202. In some embodiments, semiconductor layers 204 are silicon germanium (SiGe) while sacrificial layers 202 include a semiconductor material suitable for use as a nanoribbon such as silicon (Si), SiGe, germanium, or III-V materials like indium phosphide (InP) or gallium arsenide (GaAs). In examples where SiGe is used in each of semiconductor layers 204 and in sacrificial layers 202, the germanium concentration is different between semiconductor layers 204 and sacrificial layers 202. For example, semiconductor layers 204 may include a higher germanium content compared to sacrificial layers 202. In some examples, sacrificial layers 202 may be doped with either n-type dopants (to produce a p-channel transistor) or p-type dopants (to produce an n-channel transistor).

While dimensions can vary from one example embodiment to the next, the thickness of each semiconductor layer 204 may be between about 5 nm and about 20 nm. In some embodiments, the thickness of each semiconductor layer 204 is substantially the same (e.g., within 1-2 nm). The thickness of each of sacrificial layers 202 may be about the same as the thickness of each semiconductor layer 204 (e.g., about 5-20 nm). Each of semiconductor layers 204 and sacrificial layers 202 may be deposited using any known material deposition technique, such as chemical vapor deposition (CVD), plasma-enhanced chemical vapor deposition (PECVD), physical vapor deposition (PVD), or atomic layer deposition (ALD), or epitaxial growth.

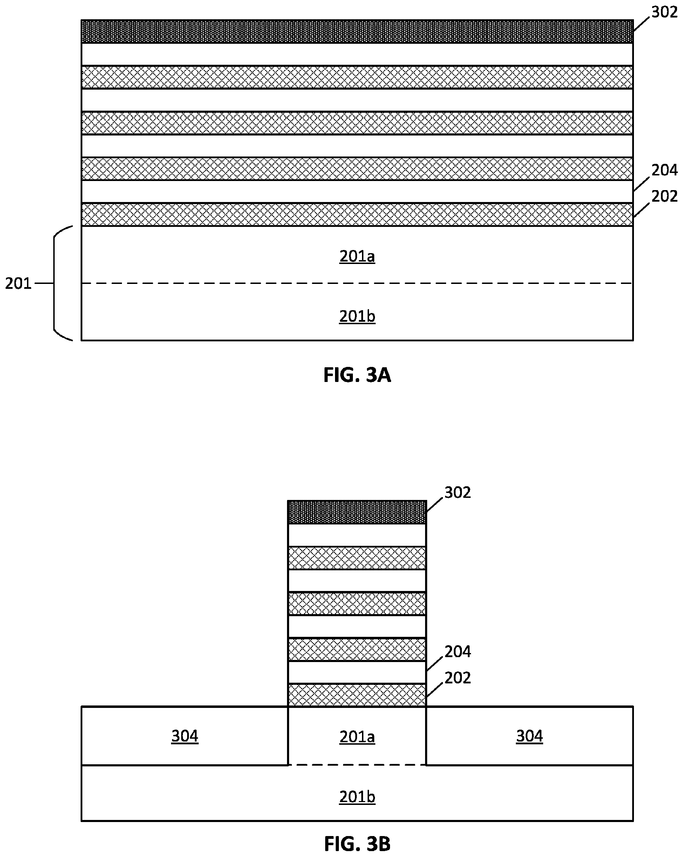

Figures 3A and 3B depict the cross-section views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows to form corresponding rows of fins from the alternating layer stack of sacrificial layers 202 and semiconductor layers 204. Cap layer 302 extends along the top of each fin in a first direction, as seen in Figure 3A.

According to some embodiments, an anisotropic etching process through the layer stack continues into at least a portion of substrate 201. Portions of substrate 201 beneath the fins are not etched and yield subfin regions 201a. The etched portion of substrate 201 may be filled with a dielectric fill 304 that acts as shallow trench isolation (STI) between adjacent fins. Dielectric fill 304 may be any dielectric material such as silicon oxide. Subfin regions 201a represent remaining portions of substrate 201 between dielectric fill 304, according to some embodiments. Subfin regions 201a may extend upwards over a bulk portion 201b of substrate 201. In some embodiments, bulk portion 201b has a thickness on the order of 100s of micrometers.

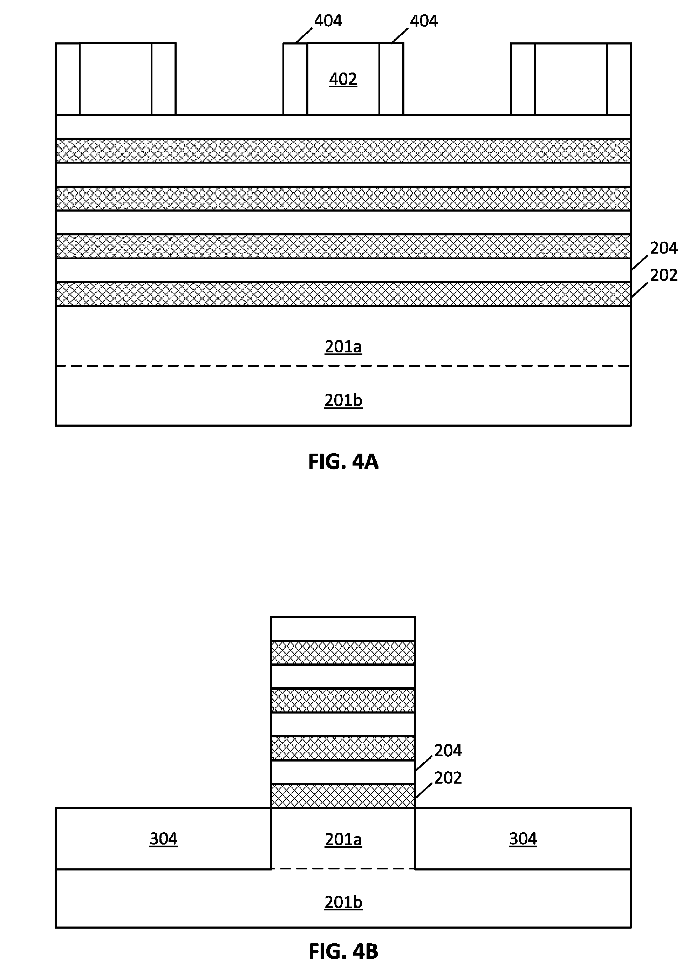

Figures 4A and 4B depict cross-section views of the structures shown in Figures 3A and 3B following the formation of sacrificial gates 402, according to some embodiments. A gate masking layer may first be patterned in strips that extend orthogonally across each of the fins (e.g., in a second direction) in order to form corresponding sacrificial gates 402 in strips beneath the gate masking layers. Afterwards, the gate masking layers may be removed or may remain as a cap layer above each sacrificial gate 402. According to some embodiments, the sacrificial gate material is removed in all areas not protected by the gate masking layers. Sacrificial gate 402 may be any material that can be selectively removed without damaging the semiconductor material of the fins. In some examples, sacrificial gate 402 includes polysilicon.

According to some embodiments, spacer structures 404 (also referred to as gate spacers or upper gate spacers) are formed along the sidewalls of sacrificial gates 402. Spacer structures 404 may be deposited and then etched back such that spacer structures 404 remain mostly only on sidewalls of any exposed structures. In the cross-section view of Figure 4B, spacer structures 404 may also be formed along sidewalls of the exposed fin over dielectric fill 304. Such sidewall spacers on the fin can be removed during later processing when forming the source or drain regions. According to some embodiments, spacer structures 404 may be any suitable dielectric material, such as silicon nitride, silicon carbon nitride, or silicon oxycarbonitride. In one such embodiment, spacer structures 404 comprise a nitride and dielectric fill 304 comprises an oxide, so as to provide a degree of etch selectivity during final gate processing. Other etch selective dielectric schemes (e.g., oxide/carbide, carbide/nitride) can be used as well for spacer structures 404 and dielectric fill 304. In other embodiments, spacer structures 404 and dielectric fill 304 are compositionally the same or otherwise similar, where etch selectivity is not employed.

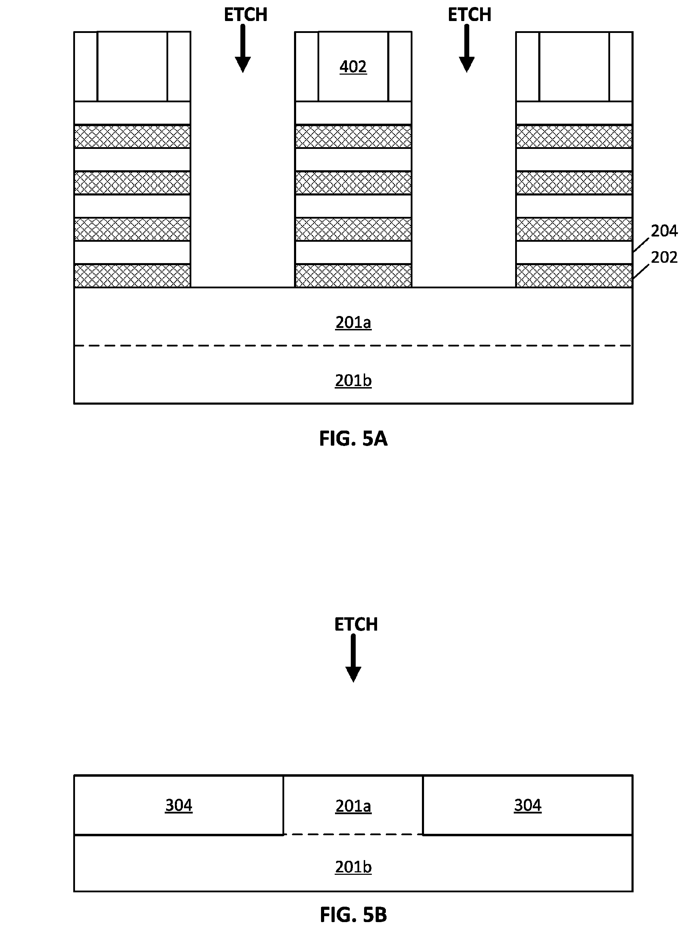

Figures 5A and 5B depict cross-section views of the structures shown in Figures 4A and 4B following the removal of exposed portions of the fins not protected by sacrificial gates 402 and spacer structures 404, according to some embodiments. The exposed fin portions may be removed using any anisotropic etching process, such as reactive ion etching (RIE). The removal of the exposed fin portions creates source or drain trenches that alternate with gate trenches (currently filled with sacrificial gates 402) along the first direction, according to some embodiments. In some embodiments, at least a portion of subfin regions 201a are also removed such that a top surface of subfin regions 201a is recessed below a top surface of dielectric fill 304. The recessed area above subfin regions 201a may be filled with one or more dielectric materials. In some embodiments, the recessed area between dielectric fill 304 is replaced with a sacrificial material (such as aluminum oxide) that can be removed at a later time from the backside to expose the underside of source or drain regions.

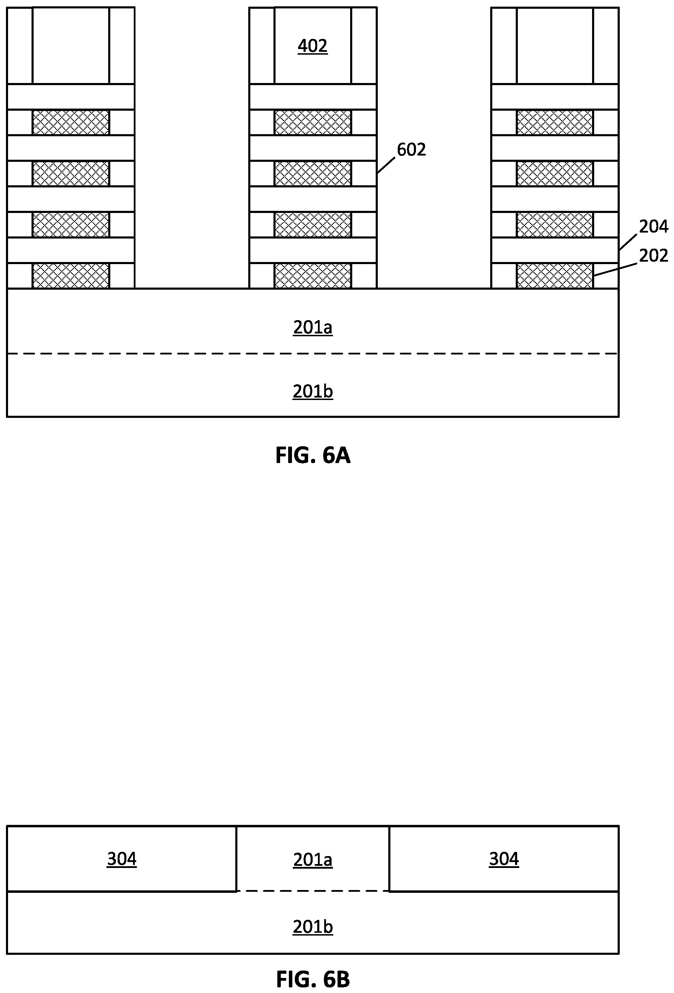

Figures 6A and 6B depict cross-section views of the structures shown in Figures 5A and 5B following the removal of portions of sacrificial layers 202 and subsequent formation of internal spacers 602 (sometimes called lower gate spacers), according to an embodiment of the present disclosure. An isotropic etching process may be used to selectively recess the exposed ends of each sacrificial layer 202 (e.g., while etching comparatively little of semiconductor layers 204). Internal spacers 602 may have a material composition that is similar to or the exact same as spacer structures 404. Accordingly, internal spacers 602 may be any dielectric material that exhibits high etch selectively to semiconductor materials such as silicon and/or silicon germanium. Internal spacers 602 may be, for example, conformally deposited over the sides of the fin structure using a conformal deposition process like CVD or ALD and then etched back using an isotropic etching process to expose the ends of semiconductor layers 204. According to some embodiments, internal spacers 602 have a similar width (e.g., along the first direction) to spacer structures 404.

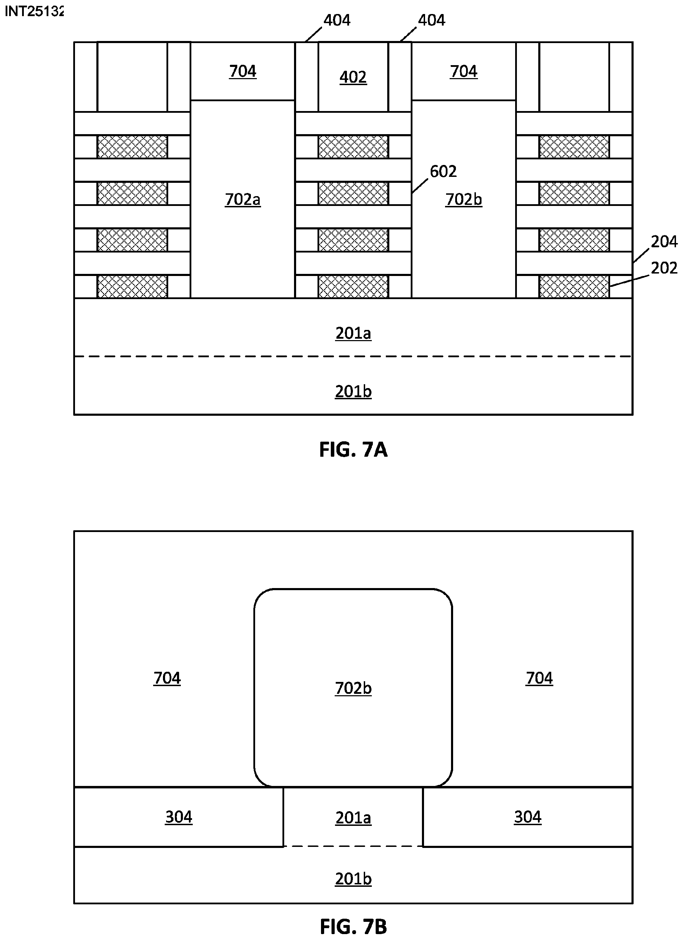

Figures 7A and 7B depict cross-section views of the structure shown in Figures 6A and 6B, respectively, following the formation of first source or drain regions 702a/702b within the source/drain trenches, according to some embodiments. First source or drain regions 702a/702b may be formed in the areas that had been previously occupied by the exposed fins between spacer structures 404. According to some embodiments, first source or drain regions 702a/702b are epitaxially grown from the exposed semiconductor material at the ends of semiconductor layers 204. In some example embodiments, first source or drain regions 702a/702b are NMOS source or drain regions (e.g., epitaxial silicon) or are PMOS source or drain regions (e.g., epitaxial SiGe).

According to some embodiments, and as seen in Figure 7B, a dielectric fill 704 is provided within the source/drain trench adjacent to first source or drain regions 702a/702b. In some examples, dielectric fill 704 occupies a remaining volume within the source/drain trench around and over first source or drain regions 702a/702b. Dielectric fill 704 may be any dielectric material, such as silicon dioxide. In some examples, dielectric fill 704 extends up to and planar with a top surface of spacer structures 404 (e.g., following a polishing procedure). A planarization process such as chemical mechanical polish (CMP) can be used to remove any excess dielectric fill 704 and planarize the structure, as shown.

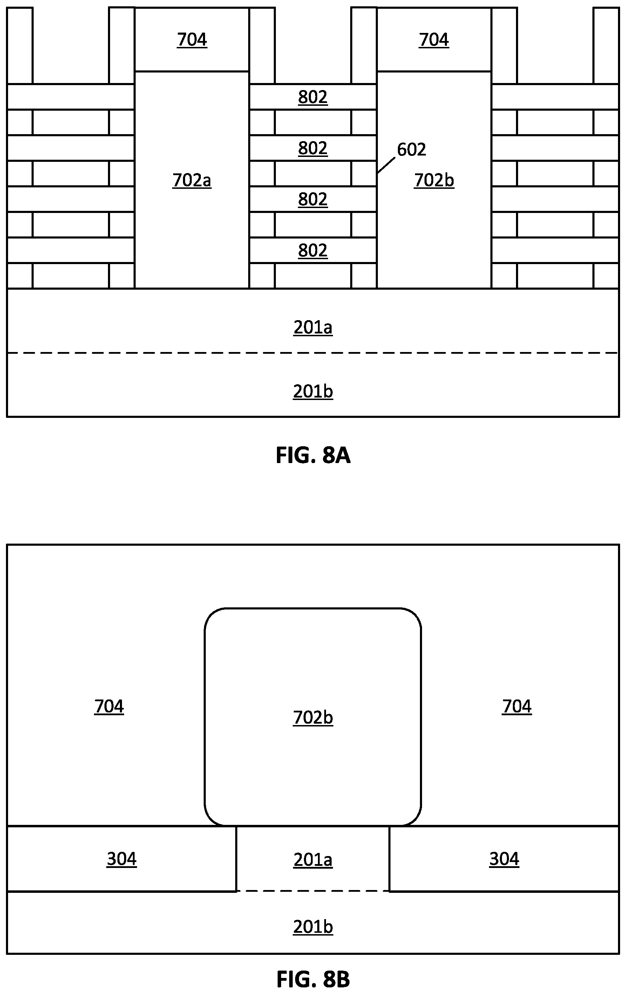

Figures 8A and 8B depict cross-section views of the structure shown in Figures 7A and 7B, respectively, following the removal of sacrificial gates 402 and sacrificial layers 202, according to some embodiments. In examples where gate masking layers are still present, they would be removed at this time. Once sacrificial gates 402 are removed, the fin extending between spacer structures 404 are exposed.

In the example where the fin includes alternating semiconductor layers, sacrificial layers 202 are selectively removed to leave behind nanoribbons 802 that extend between corresponding first source or drain regions 702a/702b. Each vertical set of nanoribbons 802 represents the semiconductor region (or channel region) of a different semiconductor device. Note that nanoribbons 802 may have any geometry and the use of the term nanoribbon is not intended to exclude any particular geometries usable for a gate-all-around channel region (such as nanowires). In other embodiments, nanoribbons 802 of a given channel region may be a single fin structure, so as to provide a double-gate or tri-gate configuration. In still other embodiments, nanoribbons 802 of a given channel region may be nanosheets extending laterally (out of page) from a dielectric wall, so as to provide a forksheet configuration. Sacrificial gates 402 and sacrificial layers 202 may be removed using the same isotropic etching process or different isotropic etching processes.

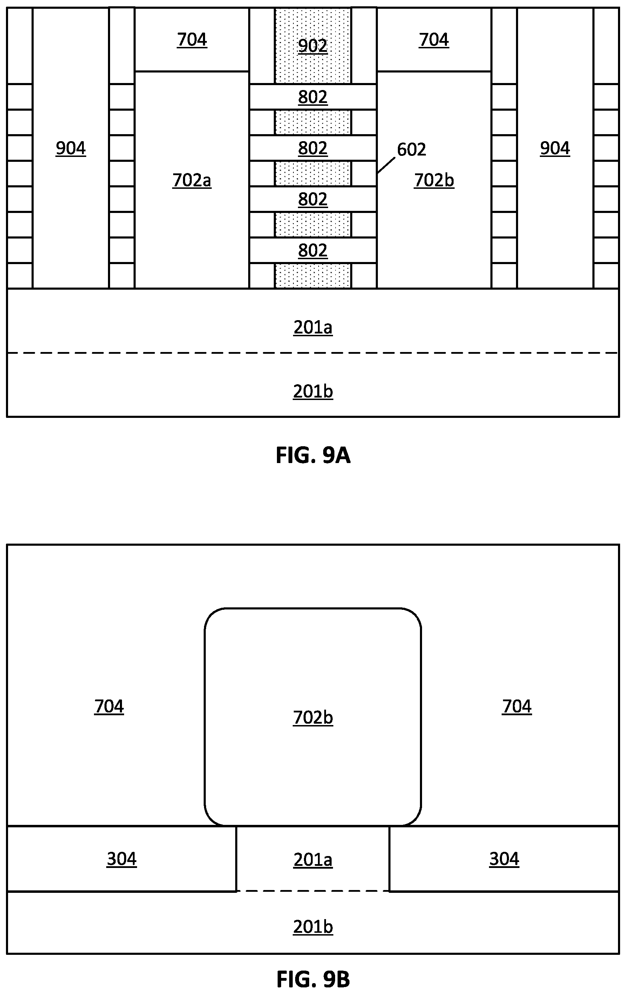

Figures 9A and 9B depict cross-section views of the structure shown in Figures 8A and 8B, respectively, following the formation of gate structures 902, which includes a gate dielectric and a gate electrode, according to some embodiments. The gate dielectric may be first formed around nanoribbons 802 prior to the formation of the gate electrode, which may include one or more conductive layers. The gate dielectric may include any gate dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric includes a layer of hafnium oxide with a thickness between about 1 nm and about 5 nm. In some embodiments, the gate dielectric may include one or more silicates (e.g., titanium silicate, tungsten silicate, niobium silicate, and silicates of other transition metals). In some cases, the gate dielectric includes a first layer on nanoribbons 802, and a second layer on the first layer. The first layer can be, for instance, an oxide of the semiconductor material of nanoribbons 802 (e.g., silicon dioxide) and the second layer can be a high-k dielectric material (e.g., hafnium oxide).

The one or more conductive layers that make up the gate electrode may be deposited using electroplating, electroless plating, CVD, PECVD, ALD, or PVD, to name a few examples. In some embodiments, the gate electrode includes doped polysilicon, a metal, or a metal alloy. Example metals or metal alloys include aluminum, tungsten, cobalt, molybdenum, ruthenium, titanium, tantalum, copper, and carbides and nitrides thereof. The gate electrode may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

According to some embodiments, an RIE process is used to remove the gate structures on either side of gate structure 902 and fill those gate trenches with a dielectric material to form isolation structures 904. Isolation structures 904 may include one or more dielectric materials that extend in the second direction within their respective gate trenches to cut through any number of fins present within those gate trenches. In the illustrated example, isolation structures 904 extend along the second direction on either side of the illustrated semiconductor device to isolate the device from any other devices formed along the first direction. Isolation structures 904 may include any suitable dielectric material, such as silicon nitride or any other oxide-based dielectric material. According to some embodiments, isolation structures 904 extend in the third direction along at least an entire height of the adjacent source or drain regions. A top surface of isolation structures 904 may be substantially coplanar with a top surface of spacer structures 404 and/or dielectric fill 704. Isolation structures 904 may not be needed in situations where adjacent devices along the first direction are intended to share a given source or drain region (or where dummy transistors are employed).

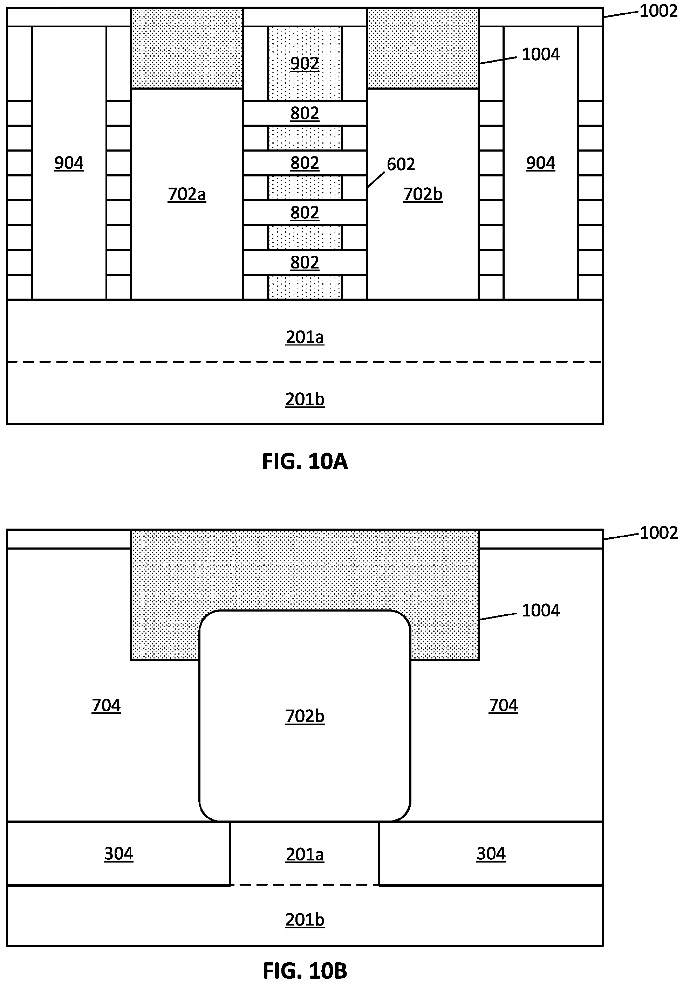

Figures 10A and 10B depict cross-section views of the structure shown in Figures 9A and 9B, respectively, following the formation of a first topside dielectric layer 1002 and topside contacts 1004, according to some embodiments. First topside dielectric layer 1002 may be deposited across the top surface of the structure and may include any suitable dielectric material, such as silicon dioxide. A masked RIE process may be used to etch through first topside dielectric layer 1002 and through a portion of dielectric fill 704 around source or drain regions 702a/702b to expose at least top surfaces of source or drain regions 702a/702b. The resulting recessed may be filled with one or more conductive materials to form topside contacts 1004. Depending on the amount of dielectric fill removed and positioning of the lithographic mask, topside contacts 1004 may contact a top surface of first source or drain regions 702a/702b and at least a portion of at least one side surface of first source or drain regions 702a/702b, according to some embodiments. More generally, topside contacts 1004 may extend along the second direction beyond the edge of first source or drain regions 702a/702b. Topside contacts 1004 may include any suitable conductive material, such as tungsten, molybdenum, ruthenium, or cobalt, to name a few examples. A top surface of topside contacts 1004 may be polished using CMP, for example, to be substantially coplanar with a top surface of first topside dielectric layer 1002.

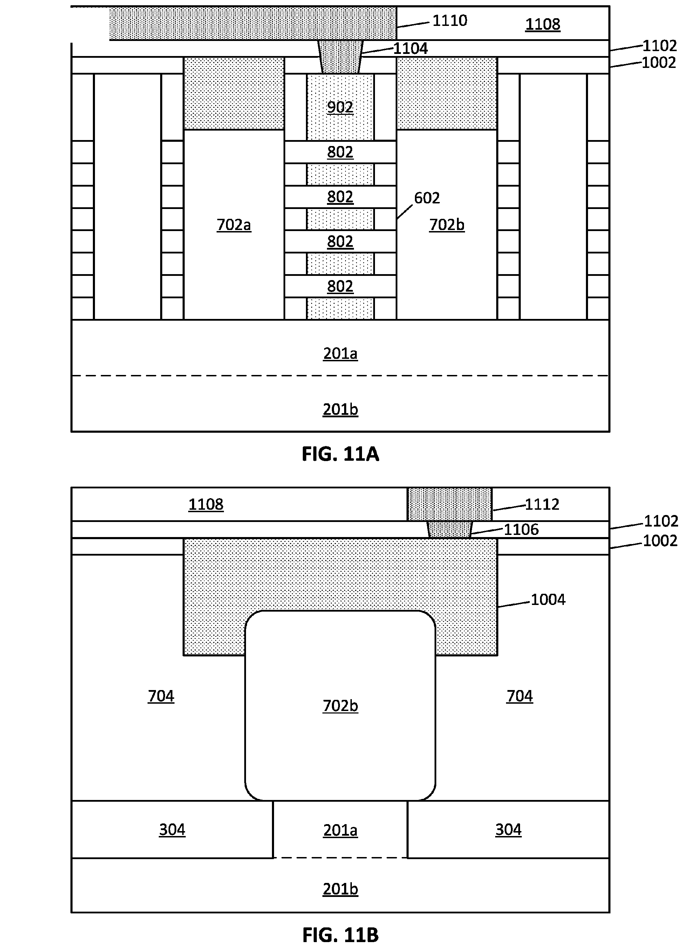

Figures 11A and 11B depict cross-section views of the structure shown in Figures 10A and 10B, respectively, following the formation of a topside interconnect region, which includes any number of interconnect layers, according to some embodiments. For example, a first topside interconnect layer may include first topside dielectric layer 1002, a second topside dielectric layer 1102, and a first via 1104 extending through both first topside dielectric layer 1002 and second topside dielectric layer 1102 to contact gate structure 902. A second via 1106 may extend through second topside dielectric layer 1102 to contact topside contact 1004 above first source or drain region 702b. A second topside interconnect layer over the first topside interconnect layer may include a third dielectric layer 1108 and a first conductive layer 1110 on first via 1104 and a second conductive layer 1112 on second via 1106. Any number of other topside interconnect layers may be formed. Dielectric layers 1102 and 1108 may be any suitable dielectric material, such as silicon dioxide. Further, each of first via 1104, second via 1106, first conductive layer 1110 and second conductive layer 1112 may include any suitable conductive material, such as tungsten, molybdenum, ruthenium, or cobalt, to name a few examples.

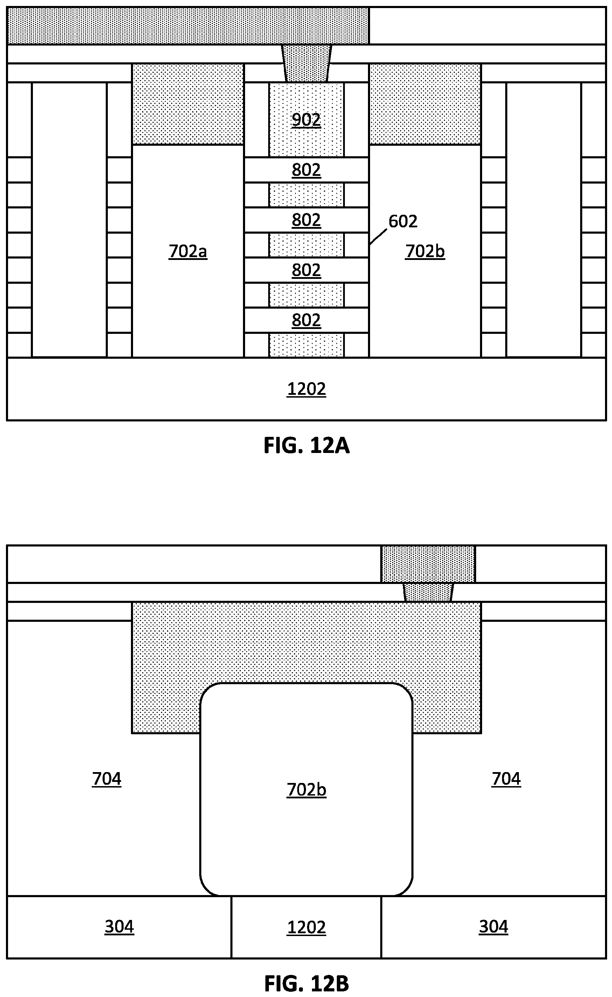

Figures 12A and 12B depict cross-section views of the structure shown in Figures 11A and 11B, respectively, following the removal of substrate 201 from the backside, which exposes subfin regions 201a and the bottom surface of dielectric fill 304, according to some embodiments. The subfin regions may be removed from the backside using a suitable isotropic etching process and replaced with any number of dielectric materials to form a dielectric base layer 1202 beneath the semiconductor devices. Dielectric base layer 1202 may include any suitable dielectric material, such as silicon dioxide, and may be polished on the backside such that its bottom surface is substantially coplanar with the bottom surface of dielectric fill 304.

Figures 13A and 13B depict cross-section views of the structure shown in Figures 12A and 12B, respectively, following the formation of a backside contact 1302 beneath first source or drain region 702b, according to some embodiments. An anisotropic etching process may be performed to etch through the dielectric material of both dielectric fill 304 and dielectric fill 704 to form a backside recess. According to some embodiments, the recess is formed directly adjacent to first source or drain region 702b such that a portion of first source or drain region 702b is exposed within the backside recess. In some examples, a dielectric liner around first source or drain region 702b (e.g., a liner of silicon nitride) protects first source or drain region 702b during the etching process. The liner may be subsequently removed to expose the semiconductor material of first source or drain region 702b. According to some embodiments, the backside recess exposes at least a portion of a bottom surface of topside contact 1004.

According to some embodiments, the backside recess is filed with one or more conductive materials to form backside contact 1302. Backside contact 1302 may include any suitable conductive material, such as tungsten, molybdenum, ruthenium, or cobalt, to name a few examples. A bottom surface of backside contact 1302 may be polished such that it is substantially coplanar with a bottom surface of dielectric fill 304 and/or dielectric base layer 1202. According to some embodiments, backside contact extends along a side of first source or drain region 702b to contact at least a portion of topside contact 1004.

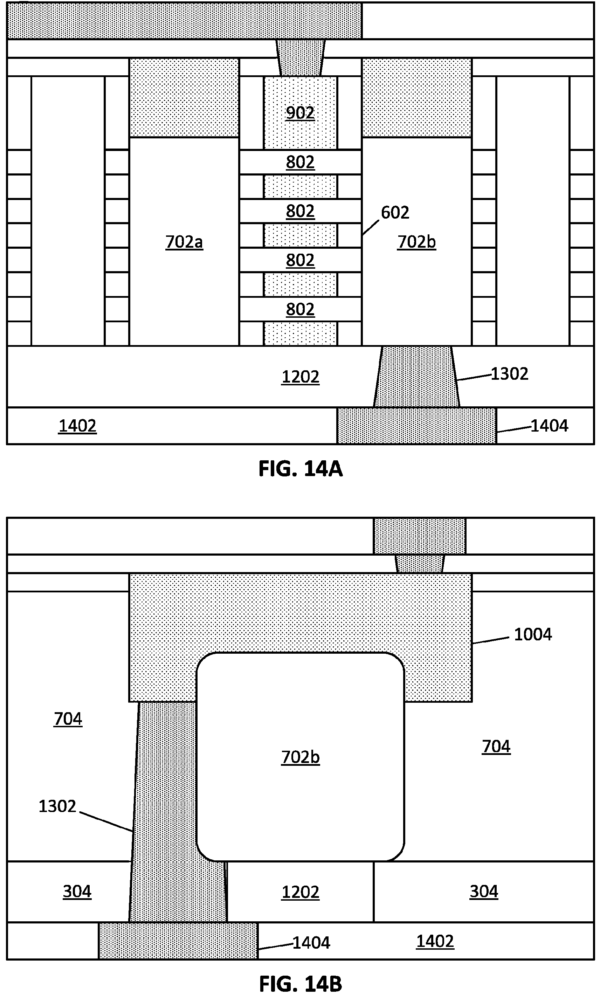

Figures 14A and 14B depict cross-section views of the structure shown in Figures 13A and 13B, respectively, following the formation of a bonding layer on the backside of the structure, according to some embodiments. The bonding layer includes a backside dielectric layer 1402 and a conductive pad 1404 formed through backside dielectric layer 1402. According to some embodiments, conductive pad 1404 is formed on the bottom surface of backside contact 1302. In some examples, conductive pad 1404 has a greater cross-sectional area compared to the cross-sectional area on the bottom surface of backside contact 1302. Backside dielectric layer 1402 may be any suitable dielectric material, such as silicon dioxide. Conductive pad 1404 may be any suitable conductive material, such as tungsten, molybdenum, ruthenium, or cobalt, to name a few examples. In some examples, conductive pad 1404 is the same conductive material as backside contact 1302.

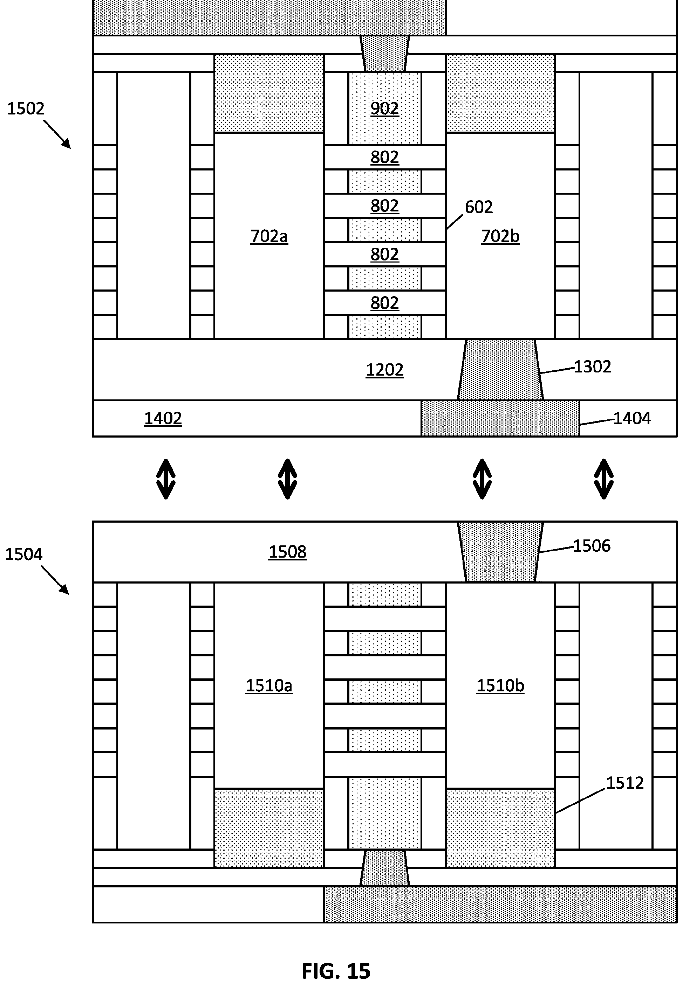

Figure 15 illustrates a cross-section view of a bonding process between a first semiconductor device 1502 and a second semiconductor device 1504, according to some embodiments. First semiconductor device 1502 may represent the device fabricated in the process illustrated in Figures 2 - 14, and second semiconductor device 1504 may represent another device on another substrate fabricated using substantially the same method. Accordingly, second semiconductor device 1504 includes a backside contact 1506 extending through a base dielectric layer 1508 that is substantially similar to backside contact 1302 of first semiconductor device 1502. Second semiconductor device 1504 also includes a semiconductor region extending between second source or drain regions 1510a and 1510b. Backside contact 1506 may also contact at least a portion of second source or drain region 1510b and extend along a side of second source or drain region 1510b to contact topside contact 1512.

According to some embodiments, the devices may be aligned such that conductive pad 1404 will align and bond with backside contact 1506. This alignment occurs across the surface of an entire wafer such that multiple devices between two wafers have backside contacts that align when the wafers are brought together, according to some embodiments. The presence of conductive pad 1404 can assist with the connection such that a small misalignment when bringing the devices together still results in a conductive path between backside contacts 1302 and 1506. Note that second semiconductor device 1504 has been flipped over in this example such that the backside of first semiconductor device 1502 is bonded to the backside of second semiconductor device 1504.

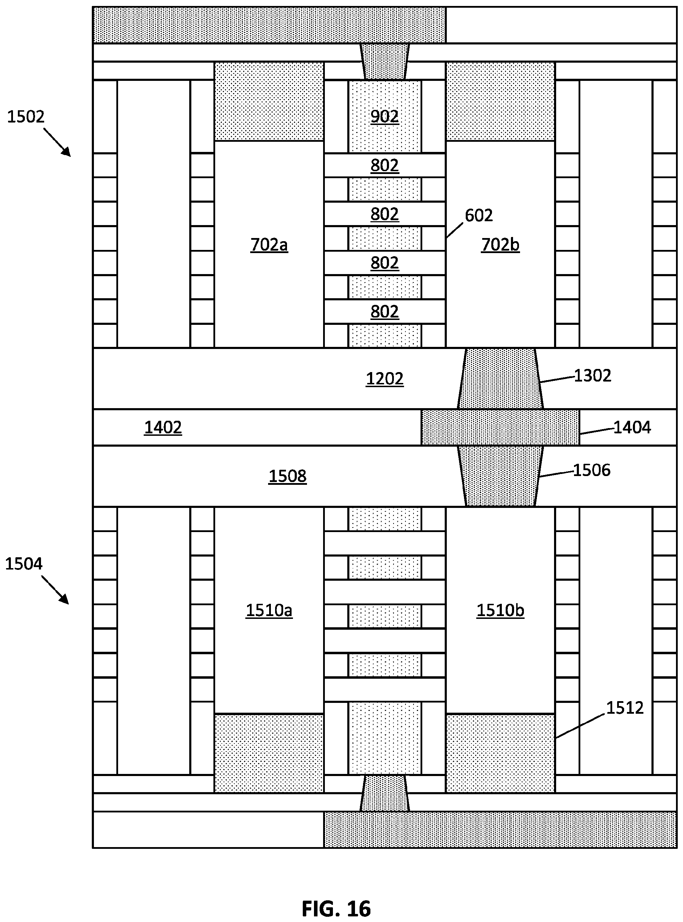

Figure 16 illustrates a cross-section view of the bonded structures having first semiconductor device 1502 and second semiconductor device 1504. A hybrid bonding procedure may be performed to form bonds at the interface between the bonding layer (including both dielectric layer 1402 and conductive pad 1404) and the bottom surface of base dielectric layer 1508 and backside contact 1506. More specifically, the dielectric surfaces (e.g., silicon dioxide surfaces) between dielectric layer 1402 and base dielectric layer 1508 form bonds at room temperature when brought into contact. The metal surfaces between conductive pad 1404 and backside contact 1506 flow together in response to the application of heat to form a metal bond across the interface. Additional heating may be applied to further compress the metal and strengthen the bond. Other bonding techniques could be utilized as well, such as eutectic bonding or plasma-activated bonding.

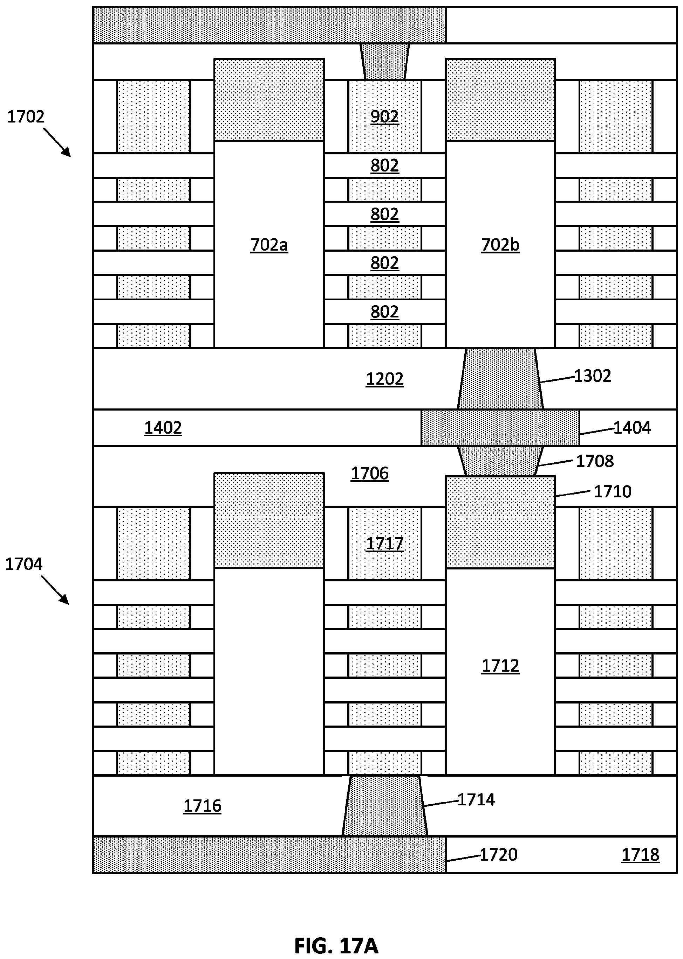

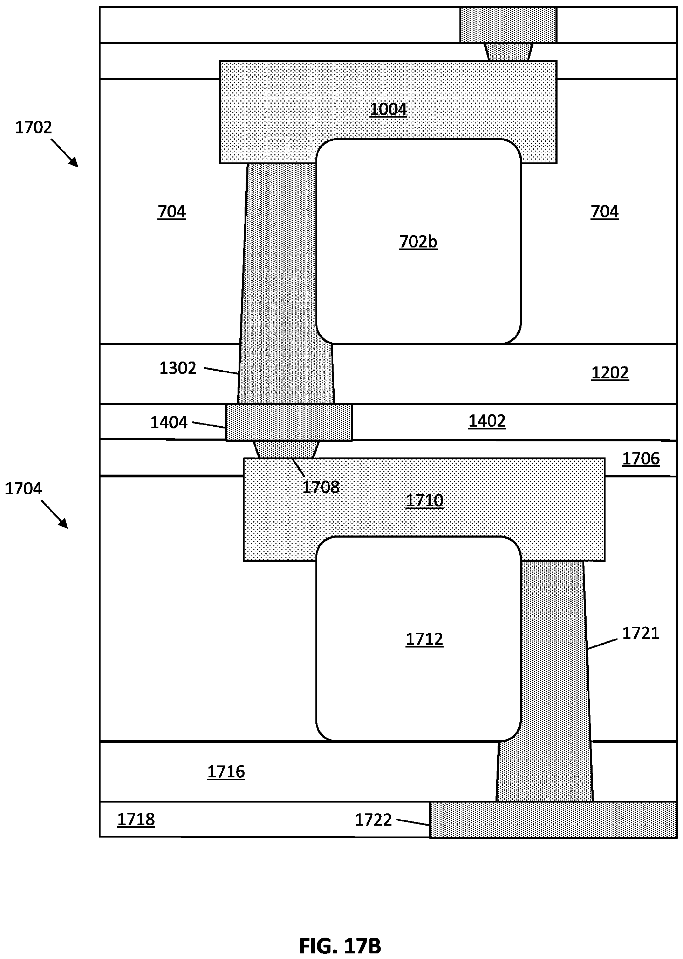

The structure described in Figures 2-16 illustrate an example where bonding occurs between the backsides of the devices. However, in some embodiments, the backside of one device may be bonded to the frontside of another device. Figures 17A and 17B depict cross-section views of a portion of an integrated circuit where the backside of a first semiconductor device 1702 is bonded to the frontside of a second semiconductor device 1704, according to some embodiments. Thus, the bonding layer, which includes dielectric layer 1402 and conductive pad 1404, is bonded to a frontside dielectric layer 1706 above the transistors of second semiconductor device 1704. A conductive frontside via 1708 extends through frontside dielectric layer 1706 to contact at least a portion of topside contact 1710 on a second source or drain region 1712. Second semiconductor device 1704 also includes a backside via 1714 extending through a first backside dielectric layer 1716 to contact the underside of a second gate structure 1717. A backside conductive layer 1720 may be present along with a second backside dielectric layer 1718 to facilitate the routing of backside signals to second gate structure 1717. According to some embodiments, each of first backside dielectric layer 1716 and second backside dielectric layer 1718 are part of a backside interconnect region that can include any number of backside layers.

As seen more clearly in Figure 16B, frontside via 1708 provides the conductive path between conductive pad 1404 of the bonding layer and topside contact 1710 on second source or drain region 1712. According to some embodiments, another backside contact 1721 is formed through various dielectric layers of second semiconductor device 1704 to contact the underside of topside contact 1710, in substantially the same manner as backside contact 1302. Backside contact 1721 may contact another conductive layer 1722 within the same plane (e.g., same metal layer) as backside conductive layer 1720. The bonding between conductive pad 1404 and frontside via 1708 and the bonding between dielectric layer 1402 and frontside dielectric layer 1706 occurs in substantially the same way as discussed above with reference to Figure 16.

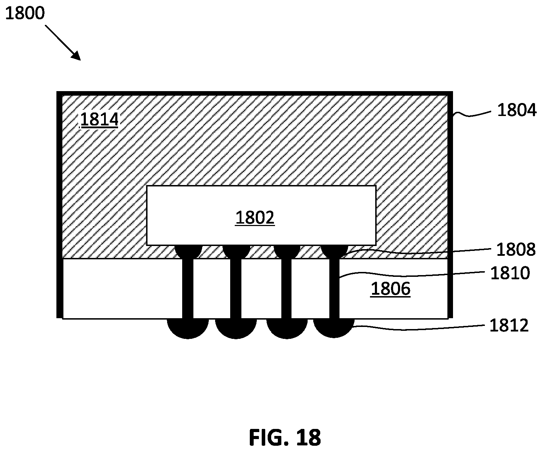

Figure 18 illustrates an example embodiment of a chip package 1800, in accordance with an embodiment of the present disclosure. As can be seen, chip package 1800 includes one or more dies 1802. One or more dies 1802 may include at least one integrated circuit having semiconductor devices, such as any of the semiconductor devices disclosed herein. One or more dies 1802 may include any other circuitry used to interface with other devices formed on the dies, or other devices connected to chip package 1800, in some example configurations.

As can be further seen, chip package 1800 includes a housing 1804 that is bonded to a package substrate 1806. The housing 1804 may be any standard or proprietary housing, and may provide, for example, electromagnetic shielding and environmental protection for the components of chip package 1800. The one or more dies 1802 may be conductively coupled to a package substrate 1806 using connections 1808, which may be implemented with any number of standard or proprietary connection mechanisms, such as solder bumps, ball grid array (BGA), pins, or wire bonds, to name a few examples. Package substrate 1806 may be any standard or proprietary package substrate, but in some cases includes a dielectric material having conductive pathways (e.g., including conductive vias and lines) extending through the dielectric material between the faces of package substrate 1806, or between different locations on each face. In some embodiments, package substrate 1806 may have a thickness less than 1 millimeter (e.g., between 0.1 millimeters and 0.5 millimeters), although any number of package geometries can be used. Additional conductive contacts 1812 may be disposed at an opposite face of package substrate 1806 for conductively contacting, for instance, a printed circuit board (PCB). One or more vias 1810 extend through a thickness of package substrate 1806 to provide conductive pathways between one or more of connections 1808 to one or more of contacts 1812. Vias 1810 are illustrated as single straight columns through package substrate 1806 for ease of illustration, although other configurations can be used (e.g., damascene, dual damascene, through-silicon via, or an interconnect structure that meanders through the thickness of substrate 1806 to contact one or more intermediate locations therein). In still other embodiments, vias 1810 are fabricated by multiple smaller stacked vias, or are staggered at different locations across package substrate 1806. In the illustrated embodiment, contacts 1812 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1812, to inhibit shorting.

In some embodiments, a mold material 1814 may be disposed around the one or more dies 1802 included within housing 1804 (e.g., between dies 1802 and package substrate 1806 as an underfill material, as well as between dies 1802 and housing 1804 as an overfill material). Although the dimensions and qualities of the mold material 1814 can vary from one embodiment to the next, in some embodiments, a thickness of mold material 1814 is less than 1 millimeter. Example materials that may be used for mold material 1814 include epoxy mold materials, as suitable. In some cases, the mold material 1814 is thermally conductive, in addition to being electrically insulating.

### Methodology

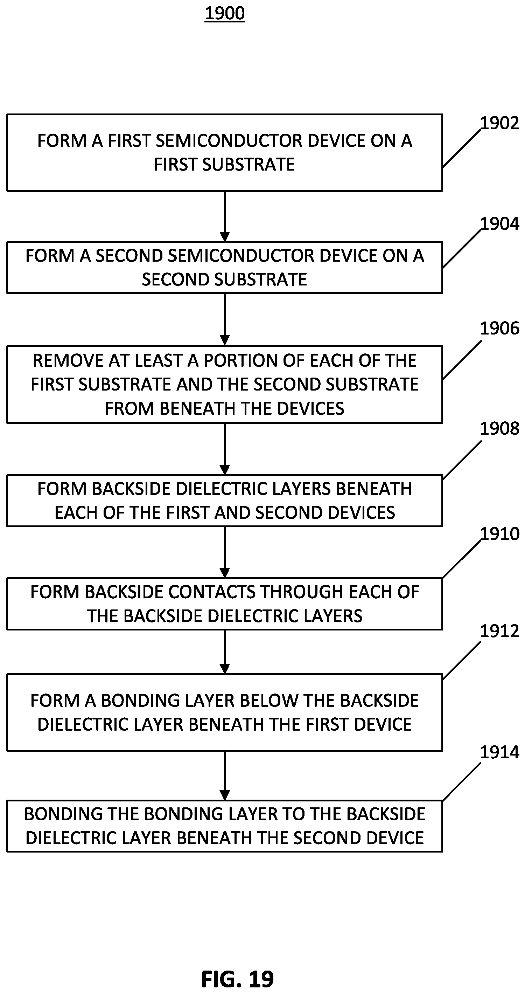

Figure 19 is a flow chart of a method 1900 for forming at least a portion of an integrated circuit, according to an embodiment. Various operations of method 1900 may be illustrated in Figures 2 - 16. However, the correlation of the various operations of method 1900 to the specific components illustrated in the aforementioned figures is not intended to imply any structural and/or use limitations. Rather, the aforementioned figures provide one example embodiment of method 1900. Other operations may be performed before, during, or after any of the operations of method 1900. For example, method 1900 does not explicitly describe various standard processes that are usually performed to form transistor structures. Some of the operations of method 1900 may be performed in a different order than the illustrated order.

Method 1900 begins with operation 1902 where a first semiconductor device is formed on a first substrate. The substrate may be a bulk semiconductor (e.g., silicon) substrate or may be a semiconductor-on-insulator (SOI) substrate. The semiconductor device may be any three-dimensional FET structure, such as a finFET, GAA structure, or forksheet structure. The aforementioned figures illustrate the example of a GAA structure having any number of nanoribbons or nanowires extending in a first direction between source or drain regions and a gate structure extending in a substantially orthogonal second direction over the nanoribbons or nanowires. Conductive topside contacts may be formed over the source or drain regions and further interconnect layers may be formed over the first semiconductor device. The interconnect layers can include any number of conductive vias and conductive layers to route signal and power to transistor elements across the integrated circuit. For example, a conductive via may be formed in an interconnect layer to contact a top surface of a topside contact on at least one of the source or drain regions.

Method 1900 continues with operation 1904 where a second semiconductor device is formed on a second substrate. The second semiconductor device and substrate may be substantially similar to the first semiconductor device and substrate.

Method 1900 continues with operation 1906 where at least a portion of each of the first substrate and second substrate are removed from beneath the respective first and second semiconductor devices. According to some embodiments, the removal of the substrates may expose bottom surfaces of subfin portions of the first and second semiconductor devices. The substrates may be removed using any number of isotropic etching, polishing, or grinding operations. The subfin portions may also be removed and replaced with any suitable dielectric material(s), such as silicon dioxide, to form first and second base dielectric layers beneath the corresponding first and second semiconductor devices.

Method 1900 continues with operation 1908 where one or more backside dielectric layers are formed. According to some embodiments, the subfin portions that remain following the removal of the first and second substrates may also be removed and replaced with any suitable dielectric material(s), such as silicon dioxide, to form first and second base dielectric layers beneath the corresponding first and second semiconductor devices. Any number of additional backside dielectric layers may also be formed.

Method 1900 continues with operation 1910 where backside contacts are formed through the base dielectric layers. According to some embodiments, the backside contacts extend beyond the bottom surfaces of the corresponding source or drain regions and continue along sides of the corresponding source or drain regions to contact the topside contacts on the top surfaces of the corresponding source or drain regions. In some examples, the backside contacts also contact the sidewalls of the corresponding source or drain regions. In some examples, the backside contacts are offset from the corresponding source or drain regions (e.g., offset along the second direction) and extend through any number of dielectric layers to contact the topside contacts. According to some embodiments, the bottom surfaces of the backside contacts are polished to be substantially coplanar with the bottom surfaces of the bottommost backside dielectric layer.

Method 1900 continues with operation 1912 where a bonding layer is formed beneath the bottommost backside dielectric layer of the first semiconductor device (or the second semiconductor device). According to some embodiments, the bonding layer includes a backside dielectric layer and a conductive pad extending through the backside dielectric layer. According to some embodiments, the conductive pad is formed on the bottom surface of the backside contact of the first semiconductor device. In some examples, the conductive pad has a greater cross-sectional area compared to the cross-sectional area on the bottom surface of the backside contact of the first semiconductor device. In some examples, the conductive pad is the same conductive material as the backside contact.

Method 1900 continues with operation 1914, where the bonding layer on the backside of the first semiconductor device is bonded to the bottommost dielectric layer on the backside of the second semiconductor device. A hybrid bonding procedure may be performed to form bonds at the interface between the bonding layer and the bottom surface of, for example, the base dielectric layer of the second semiconductor device. More specifically, the dielectric surfaces (e.g., silicon dioxide surfaces) between the dielectric layer of the bonding layer and the base dielectric layer of the second semiconductor device form bonds at room temperature when brought into contact. The metal surfaces between the conductive pad of the bonding layer and the bottom surface of the backside contact of the second semiconductor device flow together in response to the application of heat to form a metal bond across the interface. Additional heating may be applied to further compress the metal and strengthen the bond. Other bonding techniques could be utilized as well, such as eutectic bonding or plasma-activated bonding. Once bonded, a conductive path exists between the topside contact over the source or drain region of the first semiconductor device and the topside contact over the source or drain region of the second semiconductor device through each of the backside contacts. According to some embodiments, the bonding layer also provides a conductive pad to act as a conductive link between the bottom surfaces of the backside contacts.

### Example System

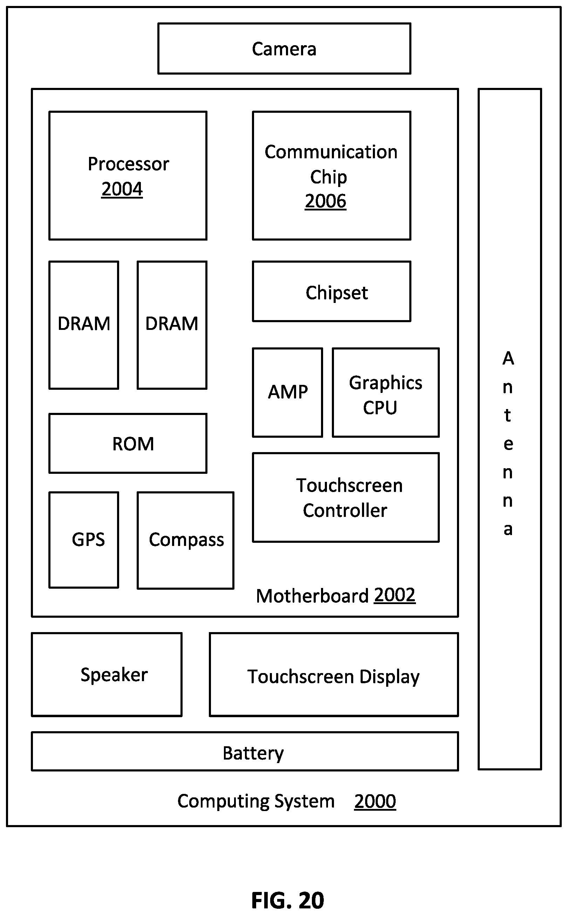

FIG. 20 is an example computing system implemented with one or more of the integrated circuit structures as disclosed herein, in accordance with some embodiments of the present disclosure. As can be seen, the computing system 2000 houses a motherboard 2002. The motherboard 2002 may include a number of components, including, but not limited to, a processor 2004 and at least one communication chip 2006, each of which can be physically and electrically coupled to the motherboard 2002, or otherwise integrated therein. As will be appreciated, the motherboard 2002 may be, for example, any printed circuit board (PCB), whether a main board, a daughterboard mounted on a main board, or the only board of system 2000, etc.

Depending on its applications, computing system 2000 may include one or more other components that may or may not be physically and electrically coupled to the motherboard 2002. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 2000 may include one or more integrated circuit structures or devices configured in accordance with an example embodiment (e.g., a module including an integrated circuit with stacked semiconductor devices that include coupled backside interconnects, as variously provided herein). In some embodiments, multiple functions can be integrated into one or more chips (e.g., for instance, note that the communication chip 2006 can be part of or otherwise integrated into the processor 2004).

The communication chip 2006 enables wireless communications for the transfer of data to and from the computing system 2000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 2006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 2000 may include a plurality of communication chips 2006. For instance, a first communication chip 2006 may be dedicated to shorter range wireless communications such as Wi-Fi and Bluetooth and a second communication chip 2006 may be dedicated to longer range wireless communications such as GPS, EDGE, GPRS, CDMA, WiMAX, LTE, Ev-DO, and others.

The processor 2004 of the computing system 2000 includes an integrated circuit die packaged within the processor 2004. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 2006 also may include an integrated circuit die packaged within the communication chip 2006. In accordance with some such example embodiments, the integrated circuit die of the communication chip includes one or more semiconductor devices as variously described herein. As will be appreciated in light of this disclosure, note that multistandard wireless capability may be integrated directly into the processor 2004 (e.g., where functionality of any chips 2006 is integrated into processor 2004, rather than having separate communication chips). Further note that processor 2004 may be a chip set having such wireless capability. In short, any number of processor 2004 and/or communication chips 2006 can be used. Likewise, any one chip or chip set can have multiple functions integrated therein.

In various implementations, the computing system 2000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 2000 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor region extending from a first source or drain region in a first direction, a first gate structure extending over the first semiconductor region in a second direction substantially orthogonal to the first direction, a second semiconductor region extending from a second source or drain region in the first direction, and a second gate structure extending over the second semiconductor region in the second direction. The second source or drain region is spaced from the first source or drain region in a third direction substantially orthogonal to the first and second directions. The integrated circuit also includes a first conductive contact extending in the third direction from the first source or drain region and contacting at least a portion of the first source or drain region, a second conductive contact extending in the third direction from the second source or drain region and contacting at least a portion of the second source or drain region, and a conductive structure between and contacting both the first conductive contact and the second conductive contact.

Example 2 includes the integrated circuit of Example 1, wherein the first source or drain region is an n-type source or drain region and the second source or drain region is a p-type source or drain region.

Example 3 includes the integrated circuit of Example 2, wherein the first source or drain region comprises silicon and phosphorous and the second source or drain region comprises silicon, germanium, and boron.

Example 4 includes the integrated circuit of any one of Examples 1-3, wherein the first semiconductor region comprises one or more first semiconductor nanoribbons and the second semiconductor region comprises one or more second semiconductor nanoribbons.

Example 5 includes the integrated circuit of Example 4, wherein the one or more first semiconductor nanoribbons and the one or more second semiconductor nanoribbons comprises germanium, silicon, or any combination thereof.

Example 6 includes the integrated circuit of any one of Examples 1-5, further comprising a dielectric layer adjacent to the conductive structure along the first direction and along the second direction.

Example 7 includes the integrated circuit of any one of Examples 1-6, further comprising a third conductive contact on the first source or drain region and a fourth conductive contact on the second source or drain region, wherein the first conductive contact contacts a portion of the third conductive contact and the second conductive contact contacts a portion of the fourth conductive contact.

Example 8 includes the integrated circuit of any one of Examples 1-7, wherein the first conductive contact and the second conductive contact comprise a same conductive material that is different than a conductive material of the conductive structure.

Example 9 includes the integrated circuit of any one of Examples 1-8, further comprising a third conductive contact extending in the third direction from the first gate structure and a fourth conductive contact extending in the third direction from the second gate structure.

Example 10 includes the integrated circuit of Example 9, wherein the third conductive contact extends in the third direction between, and contacts each of, the first gate structure and a first conductive layer, and the fourth conductive contact extends in the third direction between, and contacts each of, the second gate structure and a second conductive layer.

Example 11 is a printed circuit board comprising the integrated circuit of any one of Examples 1-10.

Example 12 is an electronic device that includes a chip package having one or more dies. At least one of the one or more dies includes a first semiconductor device having a first semiconductor region extending from a first source or drain region in a first direction, and a first gate structure extending over the first semiconductor region in a second direction substantially orthogonal to the first direction, a second semiconductor device having a second semiconductor region extending from a second source or drain region in the first direction, and a second gate structure extending over the second semiconductor region in the second direction, a first conductive contact extending in the third direction from the first source or drain region, a second conductive contact extending in the third direction from the second source or drain region, and a conductive structure between and contacting both the first conductive contact and the second conductive contact. The second source or drain region is spaced from the first source or drain region in a third direction substantially orthogonal to the first and second directions.

Example 13 includes the electronic device of Example 12, wherein the first source or drain region is an n-type source or drain region and the second source or drain region is a p-type source or drain region.

Example 14 includes the electronic device of Example 13, wherein the first source or drain region comprises silicon and phosphorous and the second source or drain region comprises silicon, germanium, and boron.

Example 15 includes the electronic device of any one of Examples 12-14, wherein the first semiconductor region comprises one or more first semiconductor nanoribbons and the second semiconductor region comprises one or more second semiconductor nanoribbons.

Example 16 includes the electronic device of Example 15, wherein the one or more first semiconductor nanoribbons and the one or more second semiconductor nanoribbons comprises germanium, silicon, or any combination thereof.

Example 17 includes the electronic device of any one of Examples 12-16, wherein the at least one of the one or more dies further comprises a dielectric layer adjacent to the conductive structure along the first direction and along the second direction.

Example 18 includes the electronic device of any one of Examples 12-17, wherein the at least one of the one or more dies further comprises a third conductive contact on the first source or drain region and a fourth conductive contact on the second source or drain region, wherein the first conductive contact contacts a portion of the third conductive contact and the second conductive contact contacts a portion of the fourth conductive contact.

Example 19 includes the electronic device of any one of Examples 12-18, wherein the first conductive contact and the second conductive contact comprise a same conductive material that is different than a conductive material of the conductive structure.

Example 20 includes the electronic device of any one of Examples 12-19, wherein the at least one of the one or more dies further comprises a third conductive contact extending in the third direction from the first gate structure and a fourth conductive contact extending in the third direction from the second gate structure.

Example 21 includes the electronic device of Example 20, wherein the third conductive contact extends in the third direction between, and contacts each of, the first gate structure and a first conductive layer, and the fourth conductive contact extends in the third direction between, and contacts each of, the second gate structure and a second conductive layer.

Example 22 includes the electronic device of any one of Examples 12-21, further comprising a printed circuit board, wherein the chip package is attached to the printed circuit board.

Example 23 is a method of forming an integrated circuit. The method includes: forming a first semiconductor device on a first substrate, the first semiconductor device having a first semiconductor region extending in a first direction from a first source or drain region and a first gate structure extending over the first semiconductor region in a second direction substantially orthogonal to the first direction; forming a second semiconductor device on a second substrate, the second semiconductor device having a second semiconductor region extending in the first direction from a second source or drain region and a second gate structure extending over the second semiconductor region in the second direction; removing at least a portion of the first substrate from beneath the first semiconductor device and at least a portion of the second substrate from beneath the second semiconductor device; forming a first backside dielectric layer beneath the first semiconductor device and a second backside dielectric layer beneath the second semiconductor device; forming a first backside contact through the first backside dielectric layer, the first backside contact contacting a surface of the first source or drain region; forming a second backside contact through the second backside dielectric layer, the second backside contact contacting a surface of the second source or drain region; forming a third dielectric layer beneath the second dielectric layer; forming a conductive structure through the third dielectric layer, the conductive structure contacting at least a portion of the second backside contact; and bonding the third dielectric layer to the first dielectric layer, such that the conductive structure is bonded to or otherwise contacts at least a portion of the first backside contact.

Example 24 includes the method of Example 23, further including: forming a first topside contact on at least a portion of the first source or drain region before removing the at least a portion of the first substrate from beneath the first semiconductor device; and forming a second topside contact on at least a portion of the second source or drain region before removing the at least a portion of the second substrate from beneath the second semiconductor device.

Example 25 includes the method of Example 24, wherein the first backside contact contacts at least a portion of the first topside contact, and the second backside contact contacts at least a portion of the second topside contact.

Example 26 includes the method of any one of Examples 23-25, wherein the bonding comprises hybrid bonding.

Example 27 is an integrated circuit that includes a first semiconductor region extending from a first source or drain region in a first direction, a first gate structure extending over the first semiconductor region in a second direction substantially orthogonal to the first direction, a second semiconductor region extending from a second source or drain region in the first direction, and a second gate structure extending over the second semiconductor region in the second direction. The second source or drain region is spaced from the first source or drain region in a third direction substantially orthogonal to the first and second directions. The integrated circuit also includes a first conductive contact on at least a portion of the first source or drain region, a second conductive contact on at least a portion of the second source or drain region, a third conductive contact adjacent to the first source or drain region and extending in the third direction from the first conductive contact, a fourth conductive contact adjacent to the second source or drain region and extending in the third direction from the second conductive contact, and a conductive structure between and contacting both the third conductive contact and the fourth conductive contact.

Example 28 includes the integrated circuit of Example 27, wherein the first source or drain region is an n-type source or drain region and the second source or drain region is a p-type source or drain region.

Example 29 includes the integrated circuit of Example 28, wherein the first source or drain region comprises silicon and phosphorous and the second source or drain region comprises silicon, germanium, and boron.

Example 30 includes the integrated circuit of any one of Examples 27-29, wherein the first semiconductor region comprises one or more first semiconductor nanoribbons and the second semiconductor region comprises one or more second semiconductor nanoribbons.

Example 31 includes the integrated circuit of Example 30, wherein the one or more first semiconductor nanoribbons and the one or more second semiconductor nanoribbons comprises germanium, silicon, or any combination thereof.

Example 32 includes the integrated circuit of any one of Examples 27-31, further comprising a dielectric layer adjacent to the conductive structure along the first direction and along the second direction.

Example 33 includes the integrated circuit of any one of Examples 27-32, wherein the first conductive contact and the second conductive contact comprise a same conductive material that is different than a conductive material of the conductive structure.

Example 34 includes the integrated circuit of any one of Examples 27-33, further comprising a third conductive contact extending in the third direction from the first gate structure and a fourth conductive contact extending in the third direction from the second gate structure.

Example 35 includes the integrated circuit of Example 34, wherein the third conductive contact extends in the third direction between, and contacts each of, the first gate structure and a first conductive layer, and the fourth conductive contact extends in the third direction between, and contacts each of, the second gate structure and a second conductive layer.

Example 36 is a printed circuit board comprising the integrated circuit of any one of Examples 27-35.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor region extending from a first source or drain region in a first direction;
a first gate structure extending over the first semiconductor region in a second direction substantially orthogonal to the first direction;
a second semiconductor region extending from a second source or drain region in the first direction, wherein the second source or drain region is spaced from the first source or drain region in a third direction substantially orthogonal to the first and second directions;
a second gate structure extending over the second semiconductor region in the second direction;
a first conductive contact extending in the third direction from the first source or drain region and contacting at least a portion of the first source or drain region;
a second conductive contact extending in the third direction from the second source or drain region and contacting at least a portion of the second source or drain region; and
a conductive structure between and contacting both the first conductive contact and the second conductive contact.

2. The integrated circuit of claim 1, wherein the first source or drain region is an n-type source or drain region and the second source or drain region is a p-type source or drain region.

3. The integrated circuit of claim 2, wherein the first source or drain region comprises silicon and phosphorous and the second source or drain region comprises silicon, germanium, and boron.

4. The integrated circuit of any one of claims 1 through 3, wherein the first semiconductor region comprises one or more first semiconductor nanoribbons and the second semiconductor region comprises one or more second semiconductor nanoribbons.

5. The integrated circuit of claim 4, wherein the one or more first semiconductor nanoribbons and the one or more second semiconductor nanoribbons comprises germanium, silicon, or any combination thereof.

6. The integrated circuit of any one of claims 1 through 5, further comprising a dielectric layer adjacent to the conductive structure along the first direction and along the second direction.

7. The integrated circuit of any one of claims 1 through 6, further comprising a third conductive contact on the first source or drain region and a fourth conductive contact on the second source or drain region, wherein the first conductive contact contacts a portion of the third conductive contact and the second conductive contact contacts a portion of the fourth conductive contact.

8. The integrated circuit of any one of claims 1 through 7, wherein the first conductive contact and the second conductive contact comprise a same conductive material that is different than a conductive material of the conductive structure.

9. The integrated circuit of any one of claims 1 through 8, further comprising a third conductive contact extending in the third direction from the first gate structure and a fourth conductive contact extending in the third direction from the second gate structure.

10. The integrated circuit of claim 9, wherein the third conductive contact extends in the third direction between, and contacts each of, the first gate structure and a first conductive layer, and the fourth conductive contact extends in the third direction between, and contacts each of, the second gate structure and a second conductive layer.

11. A printed circuit board comprising the integrated circuit of any one of claims 1 through 10.

12. A method of forming an integrated circuit, the method comprising:
forming a first semiconductor device on a first substrate, the first semiconductor device having a first semiconductor region extending in a first direction from a first source or drain region and a first gate structure extending over the first semiconductor region in a second direction substantially orthogonal to the first direction;
forming a second semiconductor device on a second substrate, the second semiconductor device having a second semiconductor region extending in the first direction from a second source or drain region and a second gate structure extending over the second semiconductor region in the second direction;
removing at least a portion of the first substrate from beneath the first semiconductor device and at least a portion of the second substrate from beneath the second semiconductor device;
forming a first backside dielectric layer beneath the first semiconductor device and a second backside dielectric layer beneath the second semiconductor device;
forming a first backside contact through the first backside dielectric layer, the first backside contact contacting a surface of the first source or drain region;
forming a second backside contact through the second backside dielectric layer, the second backside contact contacting a surface of the second source or drain region;
forming a third dielectric layer beneath the second dielectric layer;
forming a conductive structure through the third dielectric layer, the conductive structure contacting at least a portion of the second backside contact; and
bonding the third dielectric layer to the first dielectric layer, such that the conductive structure is bonded to or otherwise contacts at least a portion of the first backside contact.

13. The method of claim 12, further including:
forming a first topside contact on at least a portion of the first source or drain region before removing the at least a portion of the first substrate from beneath the first semiconductor device; and
forming a second topside contact on at least a portion of the second source or drain region before removing the at least a portion of the second substrate from beneath the second semiconductor device.

14. The method of claim 13, wherein the first backside contact contacts at least a portion of the first topside contact, and the second backside contact contacts at least a portion of the second topside contact.

15. The method of any one of claims 12 through 14, wherein the bonding comprises hybrid bonding.
